# EUROPEAN PATENT SPECIFICATION

(11) **EP 4 218 058 B1**
(45) Date of publication and mention of the grant of the patent: **12.08.2026**
(21) Application number: 21873127.1
(22) Date of filing: 07.07.2021
(51) Int. Cl.: H01F 1/42, H01F 10/32, H10D 48/00, H10K 10/46, G11C 11/16, B82Y 10/00, B82Y 25/00

(54) **SYSTEMS AND METHODS OF FABRICATING GATE ELECTRODE ON TRENCHED BOTTOM ELECTRODE BASED MOLECULAR SPINTRONICS DEVICE**
SYSTEME UND VERFAHREN ZUR HERSTELLUNG EINER GATE-ELEKTRODE AUF EINER MOLEKULAREN SPINTRONIKVORRICHTUNG MIT GRABENBODENELEKTRODE
SYSTÈMES ET PROCÉDÉS DE FABRICATION D'ÉLECTRODE DE GRILLE SUR UN DISPOSITIF SPINTRONIQUE MOLÉCULAIRE À BASE D'ÉLECTRODE INFÉRIEURE EN TRANCHÉE

(30) Priority: 25.09.2020 US 202017033552
(43) Date of publication of application: 02.08.2023
(73) Proprietor: Tyagi, Pawan, Derwood, MD 2085 (US)
(72) Inventor: Tyagi, Pawan, Derwood, MD 2085 (US)
(74) Representative: Spengler, Robert
(86) International application number: PCT/US2021/040607
(87) International publication number: WO 2022/066263

(56) References cited:
- US-A1- 2004 048 241
- US-A1- 2012 326 126
- US-A1- 2013 256 655
- US-A1- 2014 073 093
- US-A1- 2017 098 661
- US-A1- 2019 393 353
- US-A1- 2020 058 752
- US-A1- 2020 058 752
- US-A1- 2021 111 274

## Description

### BACKGROUND

One or more embodiments of the invention generally relate to fabrication of electronics or computer devices. More particularly, certain embodiments of the invention relate to fabrication of molecular electronics and molecular spintronics.

The following background information may present examples of specific aspects of the prior art (e.g., without limitation, approaches, facts, or common wisdom) that, while expected to be helpful to further educate the reader as to additional aspects of the prior art, is not to be construed as limiting the present invention, or any embodiments thereof, to anything stated or implied therein or inferred thereupon.

Document US 2020/0058752 A1 discloses a system and method for fabricating at least one of, a molecular device element and a TBELMD including depositing a first electrode material on an insulating substrate or layer, performing a photolithography process in the first electrode material, creating a trench component in the first electrode material with the photolithography process, determining a section of the electrode material to remove based on at least one of, a molecular device element and a TBELMD to be produced, removing the section of said first electrode material, oxidizing a portion of the first electrode material, creating a first insulator part from the oxidized portion of the first electrode material, in which the oxidized portion of the first electrode material includes at least a first electrode metal surface, depositing a second electrode material, and bridging the first and second electrode material.

Document US 2013/0256655 A1 discloses an active device disposed on a substrate. The active device includes a metal layer, a semiconductor channel layer, an insulating layer, a source and a drain. The metal layer has a metal oxide surface away from the substrate. The insulating layer is disposed between the metal layer and the semiconductor channel layer. The source and the drain are disposed at one side of the semiconductor channel layer. A portion of the semiconductor channel layer is exposed between the source and the drain. An orthogonal projection of the metal layer on the substrate at least covers an orthogonal projection of the portion of the semiconductor channel layer exposed by the source and the drain on the substrate.

Document US 2019/0393353 A1 discloses a semiconductor device which includes a substrate, a stack structure including gate patterns and interlayer insulating films that are alternately stacked on the substrate, an insulating pillar extending in a thickness direction of the substrate within the stack structure, a polycrystalline metal oxide film extending along a sidewall of the insulating pillar between the insulating pillar and the stack structure, a liner film having a transition metal between the insulating pillar and the polycrystalline metal oxide film, and a tunnel insulating film, a charge storage film, and a blocking insulating film which are disposed in order between the polycrystalline metal oxide film and the gate patterns.

Electronics made with silicon-based fabrication have seen steady improvements in miniaturization and performance throughout recent decades. Gordon Moore's "Moore's Law" famously predicted miniaturization and performance doubling every 18 months. As time went on it has become increasingly more difficult to keep up with this prediction. In 2015 Moore revised his law as dying in roughly the next decade. As the limits of silicon based integrated circuits (ICs) are closer, alternatives to silicon materials are being considered. One possible alternative to silicon ICs where research has shown promise is the utilization of molecular electronics and molecular spintronics.

The following is an example of a specific aspect in the prior art that, while expected to be helpful to further educate the reader as to additional aspects of the prior art, is not to be construed as limiting the present invention, or any embodiments thereof, to anything stated or implied therein or inferred thereupon. By way of educational background, an aspect of the prior art generally useful to be aware of is that while there may currently be some approaches to molecular electronics and molecular spintronics showing promise, there may generally be some concerns with fabrication of molecular electronics and molecular spintronics devices. Generally, those fabricating molecular devices may have difficulty mass producing molecular spintronics devices with conventional microfabrication tools like photolithography and sputtering machine based thin film deposition process. Generally, those fabricating molecular devices may have difficulty in conducting controlled experiments before and after completing fabrication. Generally, those fabricating molecular devices may have difficulty utilizing molecules whose typical thickness is smaller than the physical spacer between the two metal electrodes of a molecular device. Generally, those fabricating molecular spintronics may have difficulty using various configurations of ferromagnetic electrodes for making metal leads that will be connected to molecular device channels. In a prior patent, a method of making molecular devices was disclosed where the physical separation between the two conducting leads was equal to or less than the physical length of target molecule. Molecules are under the top conducting layer. In this patent, one cannot utilize small molecules that are smaller in physical length than the vertical insulating spacer between the two-conducting strip. Molecules are sandwiched between the two conducting electrodes and hence cannot be accessed by a third metal strip that may perform as a Gate electrode to tune the molecular quantum states. The invention disclosed here is produced by addressing major challenges associated with magnetic tunnel junction based molecular devices discussed in the prior work by the inventor (Tyagi, P., 2011, "Multilayer edge molecular electronics devices: a review," J. Mater. Chem., 21(13), pp. 4733-4742.).

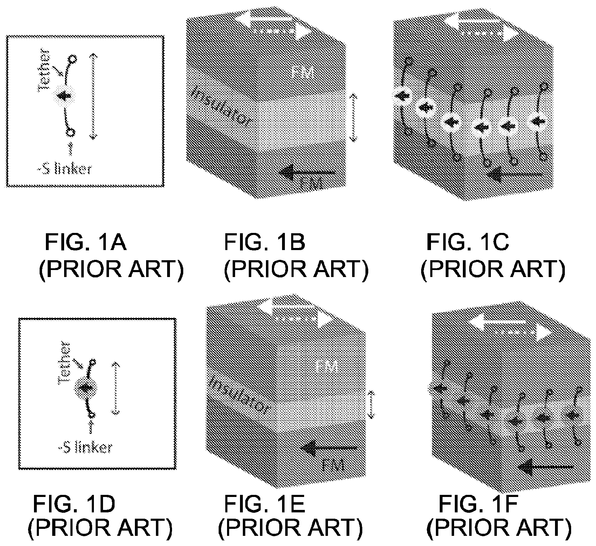

**FIG. 1** **A** to **F** illustrates prior art showing molecule focused views and side perspective views of a magnetic tunnel junction that may be transformed into molecular spintronics device typically by attaching molecular channels along the tunnel junction edge. The following is an example of a specific aspect in the prior art that, while expected to be helpful to further educate the reader as to additional aspects of the prior art, is not to be construed as limiting the present invention, or any embodiments thereof, to anything stated or implied therein or inferred thereupon. By way of educational background, an aspect of the prior art generally useful to be aware of is that all the prior work to date typically focuses on making insulator thickness less than the magnitude of molecule length. For the tunnel junction based molecular devices each molecule may usually have long tether to provide required length. To attach molecules to the metal leads or conductors' tethers may typically have thiol (-S) like linker functional group. **FIG. 1A** and **1B** are conceptual sketches showing a method of transforming a magnetic tunnel junction into molecular spintronics device. Utilization of smaller length molecules required the reduction in tunnel barrier thickness to enable the successful bridging of molecular channels between two ferromagnetic metals. Two examples are discussed to clarify limitations of the past work. **FIG. 1A** illustrates a long target molecule where the length may usually be 3.5 nm. In **FIG. 1B** a tunnel junction may typically have < 3.5 nm insulator thickness. **FIG. 1C** illustrates attaching the end of the molecular channels conventionally to the first and second ferromagnetic (FM) electrodes for a molecular spintronics device. However, thick insulator and long molecules typically may demand high operational electric power. High power requirement may usually lead to joule heating that may usually damage the molecular device channels. High heat may also typically lead to the classic heating issues with the current technology. Utilization of long molecule may conventionally also impact the spin coherence length and time. To avoid heating issues and to achieve high spin coherence short molecules may typically be used. Ability to utilize short to long molecules also may typically provide an ability to control the wave function overlap between molecule core and metal electrodes. However, utilization of short molecule typically necessitates a much thinner insulator that may usually be extremely difficult to produce over a large area and with a long operational life. For example, to integrate in **FIG. 1D** a short molecule of ~1.5 nm length, we may typically use a magnetic tunnel junction with ~ 1 nm insulator thickness in **FIG. 1E. FIG. 1F** illustrates a short molecule may usually bridge across the ~ 1 nm insulator to complete the transformation of a magnetic tunnel junction for a molecular spintronics device.

The challenge in using ~ 1 nm tunnel barrier may typically be extreme. It may conventionally be extremely challenging to produce atomically smooth and uniform thickness insulator by the industrially suitable sputtering process. Similarly, recent approaches like atomic layer deposition (ALD) may need to overcome complex technical challenges to deliver robust ultrathin insulator on various types of magnetic electrodes and metal electrodes. Thin tunnel barrier may usually be highly likely to have pin holes, or pathways for the hot electrons leading to high background current. High background current may typically mask the effect of molecules. Moreover, mechanical stresses that normally get generated during fabrication and utilization of a device may also typically easily damage a thin tunnel barrier.

To advance molecular spintronics area one may need to make actual devices with long interconnects to read and write signals. Ability to read and write signal from the molecular spintronics device may allow the development of significantly improved logic and memory devices that may work based on molecular quantum states.

In view of the foregoing, it is clear that these traditional techniques are not perfect and leave room for more optimal approaches.

### BRIEF DESCRIPTION OF THE DRAWINGS

The present invention is illustrated by way of example, and not by way of limitation, in the figures of the accompanying drawings and in which like reference numerals refer to similar elements and in which:
**FIGs. 1** **A** to **F** illustrate prior art showing molecule focused views and side perspective views of a magnetic tunnel junction that may be transformed into molecular spintronics device typically by attaching molecular channels along the tunnel junction edge;
**FIGs. 2** **A** to **G** illustrate the inventor's prior approach showing graphs that may show proof of concept and scope of making magnetic tunnel junction based molecular devices, where **FIGs. 2** **A - C** are in reference to a magnometer, **FIGs. 2** **D - E** are in reference to a ferromagnetic resonance, and **FIGs. 2** **F - G** are in reference to a magnetic force microscopy;
**FIGs. 3A** and **3B****,** illustrate cross-sectional views, respectively, of exemplary Trenched Bottom Electrode and Liftoff based Molecular Devices (TBELMDs), wherein 3A illustrates a device with two terminals and **3B** illustrates a device with three terminals;
**FIGs. 4** **A** to **N** to, illustrate, by way of example, side cross-section views of the components of TBELMD formed at each ordered stage of an exemplary fabrication method for producing trenched bottom electrode based molecular devices, wherein **FIGs. 4 A-D** illustrate the initial stages in common, **FIGs. 4 E-I** illustrate subsequent stages done according to an exemplary alternative exemplary method **"A",** and **FIGs. 4 J-N** illustrate those stages done instead according to an exemplary alternative exemplary method " **B";**
**FIGs. 5A-H** illustrate, by way of example, side cross-section views of the components of TBELMD formed at each stage of an exemplary alternative exemplary method (referred to as method "**C**") for fabrication of a trenched bottom electrode based molecular devices for the cases when bottom electrode be oxidized to produce insulator-1 **520;**
**FIGs. 6 A-I** illustrate, by way of example, side cross-section views of the components of TBELMD formed at each stage of an exemplary alternative exemplary method (referred to as method "**D**") for fabrication of trenched bottom electrode based molecular devices for the cases when bottom electrode cannot be oxidized to produce insulator-1;
**FIG. 7 A** to **H** illustrate, by way of example, various top and side perspective views of the components of TBELMD formed at each stage of an exemplary process flow for creating the exemplary trenched bottom electrode based molecular devices;
**FIGs. 8 A-E** illustrate side cross-section views of the before, during, and after states of exemplary molecules for the exemplary molecular device during the exemplary method of attaching molecules shown in **FIG. 7** for the present molecular device, where **FIG. 8** **A** illustrates molecules before and after deprotecting a thiol group, **FIGs. 8** **B** and **C** illustrate electrophoretically concentrating molecules near a junction, and **FIG. 8** **D** and **FIG. 8** **E** illustrate removing protection group from thiol to facilitate metal-molecule chemical bonding;
**FIGs. 9 A-D** illustrate a cross sectional view along a bottom layer of an exemplary TBELMD based molecular spin valve device during the mechanism of a two terminal TBELMD serving as an exemplary spin valve type memory device, where **FIG. 9** **A** and **FIG. 9** **B** illustrate Alkane like simple molecular device elements, and **FIG. 9** **C** and **FIG. 9** **D** show molecules with tunable quantum states;
**FIG. 10** **A** to **J** illustrate, by way of example, various top and side perspective views of an exemplary three terminal TBELMD where a third metal electrode selves as a Gate, at each stage of an exemplary process flow for creating;

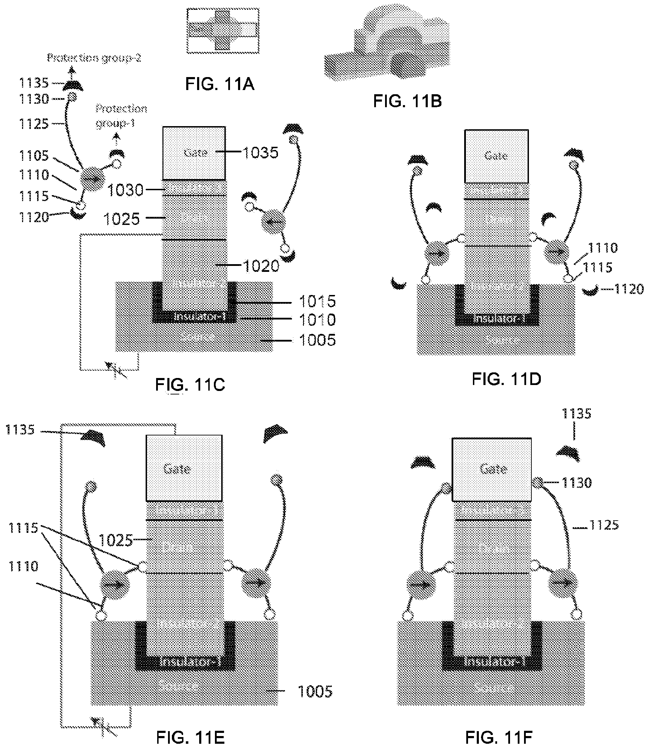

**FIGs. 11 A-F** illustrate top, side perspective and cross sectional views of a required exemplary form of the molecule and the method of bonding the same molecule to the three metal strips to form the field effect based molecular devices, where the top view **FIG. 11** **A** shows chemically bonding of the molecules with the metal strips that may require the submerging of the junction into a molecular solution, side perspective view **FIG. 11** **B** shows the 3D side view of the junction, and cross sectional view **FIG. 11** **C** shows electrophoretically concentrated molecules near a junction, **FIG. 11** **D** shows selective removal of protection group-1 to connect a molecule to source and drain metals, **FIG. 11** **E** shows selective removal of protection group-2 by applying a bias on Gate electrode, **FIG. 11** **F** shows a long tether getting attached to a Gate electrode;
**FIGs. 12** **A** and **B** illustrate cross sectional views of an exemplary three terminal molecular device serving as a logic device, where **FIG. 12A** shows stage-1, and **FIG. 12B** shows stage-2;
**FIG. 13** illustrates a side perspective view of an exemplary three terminal TBELMD utilizing multicore molecule for producing novel computer devices, energy sensors, and chemical sensors;
**FIG. 14** illustrates a cross sectional view of an exemplary two terminal TBELMD based Spinterface device;
**FIG. 15** illustrates a flowchart of a method for fabricating an exemplary trenched bottom metal electrode and liftoff based molecular device;
**FIG. 16** illustrates a flow chart of a method for forming exemplary components of TBELMD (referred to as method "**C**") for fabrication of a trenched bottom electrode based molecular devices for the cases when bottom electrode cannot be oxidized to produce insulator 1;
**FIG. 17A** illustrates a flow chart of a method for forming semiconductor structures (referred to as method "**D**") for fabrication of trenched bottom electrode based molecular devices for the cases when bottom electrode cannot be oxidized to produce insulator 1;
**FIG. 17B** illustrates a flow chart of a process where the 1st metal electrode will be oxidized to produce the 1st insulator, in accordance with an embodiment of the present invention;
**FIGs. 18A-C** illustrate variations of an exemplary TBELMD, wherein **FIG. 18A** shows a standard TBELMD, **FIG. 18B** shows a TBELMD with a gate electrode in a deep trench, and **FIG. 18C** shows a TBELMD with a gate electrode in a drain electrode, in accordance with an embodiment of the invention;

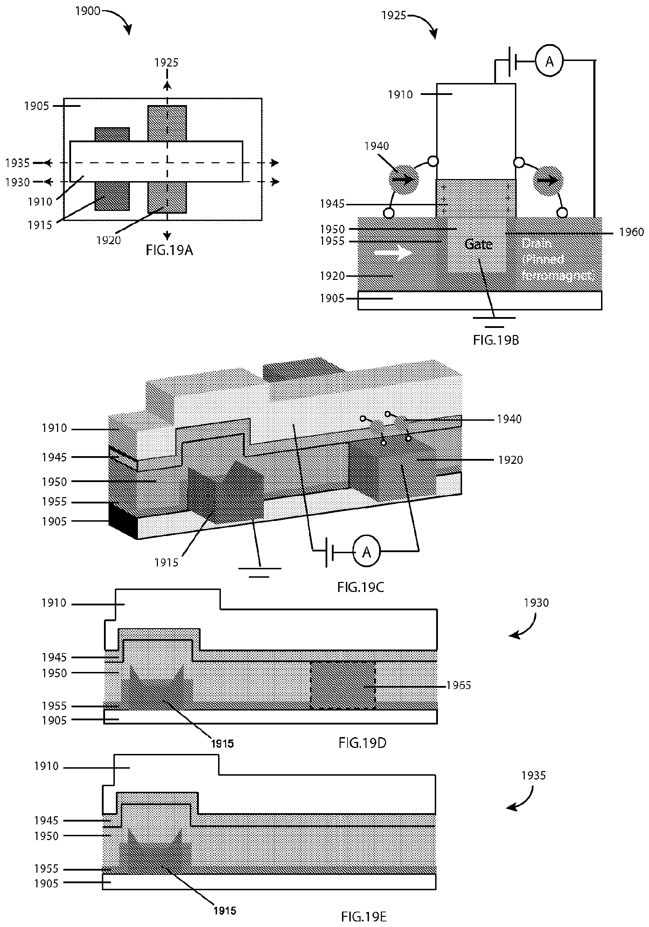

**FIGs. 19A-E** illustrate an exemplary TBELMD with a gate electrode within a drain area, wherein **FIG. 19A** illustrates a top view of a TBELMD with a gate electrode within a drain area, **FIG. 19B** illustrates a first cross-sectional view of a TBELMD with a gate electrode within a drain area, **FIG. 19C** illustrates a 3D view of a TBELMD with a gate electrode within a drain area, **FIG. 19D** illustrates a second cross-sectional view of a TBELMD with a gate electrode within a drain area, and **FIG. 19E** illustrates a third cross-sectional view of a TBELMD with a gate electrode within a drain area, in accordance with an embodiment of the invention;
**FIGs. 20A-K** illustrate, by way of example, various top and cross-sectional views of the components of an exemplary TBELMD with a gate electrode within a drain area, at each stage of an exemplary process flow for creating the TBELMD with a gate electrode within a drain area, in accordance with an embodiment of the invention; and
**FIGs. 21A-M** illustrate, by way of example, various top and cross-sectional views of the components of an exemplary TBELMD with a gate electrode in a deep trench, at each stage of an exemplary process flow for creating the TBELMD with a gate electrode in a deep trench, in accordance with an embodiment of the invention.

Unless otherwise indicated illustrations in the figures are not necessarily drawn to scale.

### DETAILED DESCRIPTION

The present invention is best understood by reference to the detailed figures and description set forth herein.

An embodiment of the present invention may provide improved fabrication for molecular devices. Some embodiments may provide a method of the tunnel junction based molecular spintronics device design, where the length of a molecular device channel may be smaller than the combined thickness of the insulating barriers in the planar area of the trench on a conducting strip. This arrangement may enable the molecular device channels to dominate the charge and spin transport via the insulating spacer. In addition, some embodiments may provide a tunnel junction test bed that may be used to allow molecules to perform as the molecular device channels. The insulating spacer between two metal electrodes may take care of the responsibility of maintaining two metal leads physically separated. In addition, some embodiments may provide a fabrication procedure accomplished preferably below 100°C to avoid damage to ferromagnetic electrodes in the ambient condition. TBELMD fabrication procedure may also include fabrication steps, such as annealing of tunnel junction before coupling molecules between two metal electrodes, involving as high as 300°C in the inert environment. Molecules may be connected to metal leads by the self-assembly in a manner that do not damage the molecules.

Some embodiments may provide an ability to utilize multilayer ferromagnetic electrodes. In addition, some embodiments may provide an ability to make magnetic metamaterials by combining magnetic tunnel junctions and molecular device channels. These TBELMD based metamaterials may have entirely different magnetic, optical, and transport properties as compared to the magnetic tunnel junction and molecules which are utilized for making TBELMD. TBELMD based magnetic metamaterial provide an improved method of producing a molecular device that can exhibit solar cell effect. In the prior work a molecular device where bottom electrode did not possess a trench exhibited solar cell effect. But the prior approach was extremely limited in scope because molecule length must be more than the planar tunneling barrier thickness and under this condition one cannot produce large area solar cell. In addition, some embodiments may provide an ability to make memory devices where the magnetic states of molecules, top magnetic layer, and bottom magnetic layers may be manipulated individually. In addition, some embodiments may provide an ability to utilize molecular "spin" channels for sensing chemicals. In addition, some embodiments may provide an ability to utilize molecular "spin" channels for sensing light.

An aspect of the present embodiment is to detail a trenched bottom electrode based method for making mass producible molecular spintronics devices. An aspect of the present embodiment is to disclose a method of addressing the issues associated with the utilization of ~ 1 nm length scale molecules. An aspect of the present embodiment may also be to focus on making mass producible molecular spintronics devices.

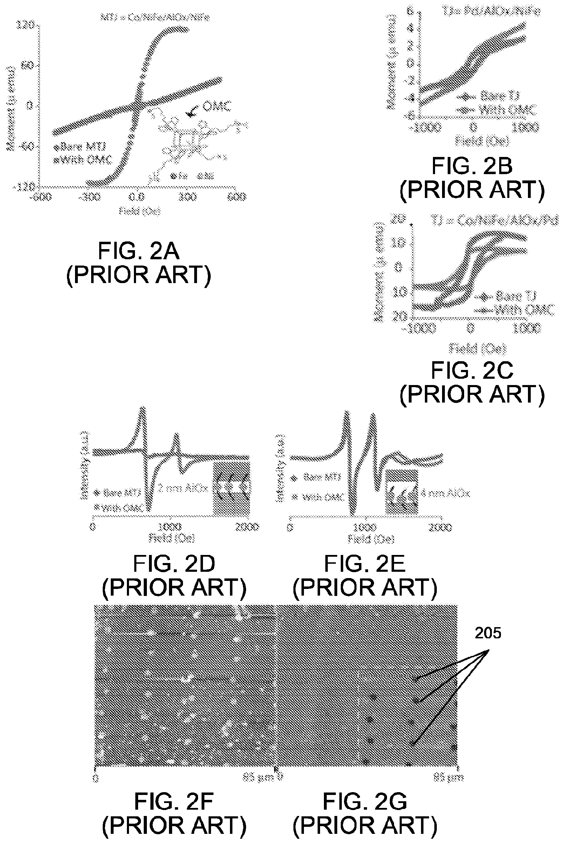

**FIGs. 2A** to **2G** illustrate the inventor's prior approach showing graphs that may show proof of concept and scope of making magnetic tunnel junction based molecular devices, where **FIGs. 2A** to **C** are in reference to a magnometer, **FIGs. 2D** to **E** are in reference to a ferromagnetic resonance, and **FIGs. 2F** to **G** are in reference to a magnetic force microscopy. The following is an example of a specific aspect in the prior art that, while expected to be helpful to further educate the reader as to additional aspects of the prior art, is not to be construed as limiting the present invention, or any embodiments thereof, to anything stated or implied therein or inferred thereupon. By way of educational background, an aspect of the prior art generally useful to be aware of is that molecules may typically show transformative effect when connected to bottom or first magnetic electrode and the second ferromagnetic electrode. A group of magnetic tunnel junction (MTJ) pillars were studied before and after attaching molecular channels. Each MTJ pillar may typically have been a stack of cobalt (Co)/permalloy (NiFe)/Insulator (~2 nm AlOx)/NiFe. Molecules utilized in this study may typically have been organometallic molecular complex (OMC) and usually may have possessed ~3 nm end to end length. The core of OMC (inset of **FIG. 2A**) may conventionally have been connected to four tethers, each ending with -S linker, to typically provide molecule sufficient length and ability to make covalent bond with the metal layer adjacent to insulator. Three independent measurements were performed to strongly evidence that adding molecule on the magnetic tunnel junction (MTJ) typically produced transformative changes. Magnetometer study was usually conducted on three types of tunnel junctions.

**FIG. 2A** illustrates a typical magnetization loop from aforementioned bare MTJ turned into linear type after hosting OMCs along the edges. The OMCs established strong antiferromagnetic coupling between the two ferromagnetic electrodes of the tunnel junction leading to observed response in **FIG. 2A****.** OMC impact was typically different for different tunnel junction. OMCs could usually **FIG. 2B** decrease or **FIG. 2C** increase the magnetic moment. **FIG. 2D** illustrates a ferromagnetic resonance study showing OMC normally made the typical resonance modes disappear after getting bridged across insulator of MTJ. In **FIG. 2E** however, OMCs could usually not impact MTJ that had thickness higher than the molecule length. Additionally, magnetic force microscopy may typically be an approach that seek magnetic signals from the physical magnetic tunnel junction sites (topography panel). **FIG. 2F** illustrates a topography panel suggesting the usual presence of an array of OMC treated magnetic tunnel junctions. **FIG. 2G** illustrates a magnetic image panel showing the usual magnetic signal from the magnetic tunnel junctions with OMC bridges, similar to **FIG. 1C****.** OMCs conventionally made a majority of the MTJ lose the magnetic contrast. Dark dots in the dashed line region **205** represent MTJ which were typically not affected by the OMCs. **FIG.2** shows that a magnetic tunnel junction hosting molecule along the exposed side edges can be a useful testbed for harnessing molecules as a device element.

Data shown in panel **FIG. 2G** exposes two more pertinent typical limitations of the inventor's entire prior approach in the area of molecular device fabrication. For the first limitation Panel **FIG. 2G** confirms that inventor's prior approach was usually not a high yield process for transforming a large group of tunnel junctions into molecular devices. For the second limitation it is conventionally not enough to make molecular spintronics devices in isolated pillar form without connection to outer world. This pillar form device structure may not typically take the advantage of etching the bottom electrode to reduce the minimum space between top and bottom ferromagnetic layer. As it is obvious, top, and bottom ferromagnetic layers may usually be of the same area in a pillar.

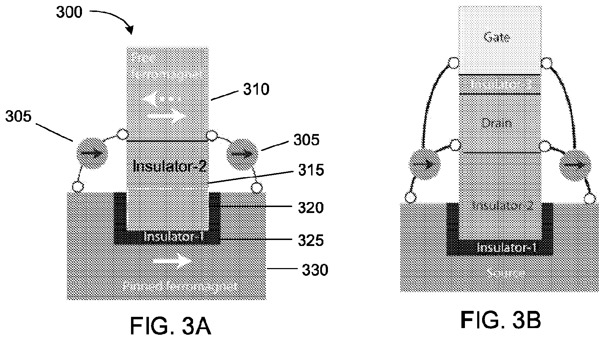

**FIGs. 3A** and **3B****,** illustrate cross-sectional views, respectively, of exemplary Trenched Bottom Electrode and Liftoff based Molecular Devices (TBELMDs), wherein **FIG. 3A** illustrates a device with two terminals and **FIG. 3B** illustrates a device with three terminals. **FIG. 3A** illustrates a two terminal TBELMD **300,** in the present example it may primarily be intended to serve as memory device, logic device, light sensor, chemical sensor, biochemical sensor, and logic devices relying on the molecular quantum state. To utilize electron spin for the devices and sensors at least one of the conducting strips may be made up of magnetic material. Magnetic materials may be nickel, iron, cobalt, and magnetic alloys like NiFe and CoFeB etc. Conducting strips may contain films of multiple materials to realize different magnetic hardness. Selection of magnetic materials like nickel may produce the direction of magnetic moment parallel to the plane of the films, as illustrated in **FIG. 3A****.** However, CoFeB may produce direction of magnetic moment perpendicular to the plane of the films. Molecular channels **305** may be bridged between two conducting strips **310** and **330** to transform a magnetic junction into molecular spintronics device **300.** The cross-section side view along the second conducting strip shows a more pertinent feature of this invention. A first conducting strip **330,** also referred as a bottom electrode, may possess a trench **320.** Trench **320** is the area in bottom electrode **330** that was removed and then filled with at least one insulator to ensure that conducting strips **310** and **330** are not directly in contact with each other. In the exemplary drawing **FIG. 3A****,** trench region **320** is filled with a portion of insulator-2 **315.** At least one insulator **325** may be accommodated in trench **320.** The thickness and width of insulator-1 **325,** thickness of insulator-2 **315,** and depth of trench **320** may be adjusted to accommodate very small molecules with less than 1 nm length to very large molecule of even more than 10 nm length. As a design merit the leakage current via insulator-1 **325** and insulator-2 **315** may be extremely low and typically less than 1 mA/cm² tunnel junction area. In a 25-micron (5 um x 5um) junction area, an extremely low current should be smaller than 1 nA. Low leakage current may enable molecules to dictate the charge and spin transport via them. As a more pertinent attribute, the combined thickness of insulator-1 and insulator-2 may be significantly more than that of the target molecule length. A thick insulator in the planar area may reduce the adverse impact of defects on the molecular spintronics device performance and long-term stability. Setting the alignment of free ferromagnetic layer **310** parallel to pinned layer **330** may give a high current flow, however the antiparallel state may set the low current state. **FIG. 3B** illustrates a three-terminal version of TBELMD **300** that may serve as a logic device.

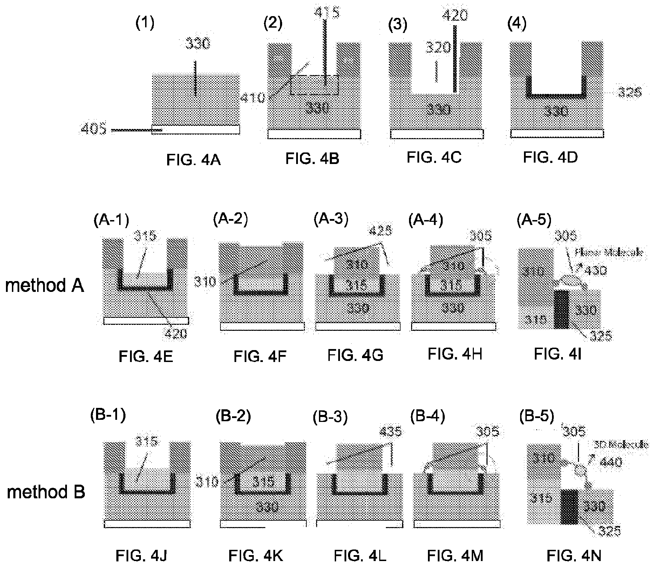

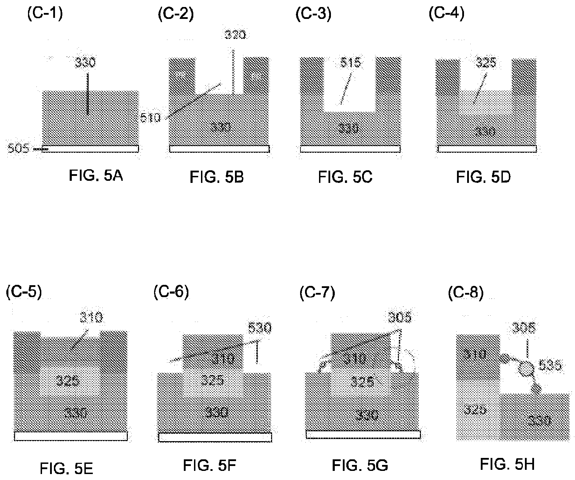

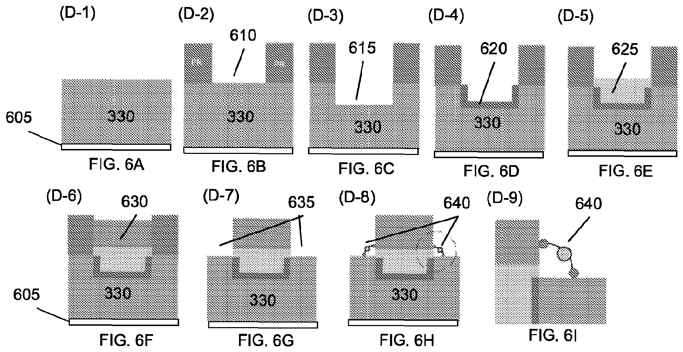

**FIGs. 4** **A** to **N** illustrate, by way of example, side cross-section views of the components of TBELMD **300** formed at each ordered stage of an exemplary fabrication method for producing trenched bottom electrode based molecular devices, wherein **FIGs. 4 A-D** illustrate the initial stages in common, **FIGs. 4 E-I** illustrate subsequent stages done according to an exemplary alternative exemplary method **"A",** and **FIGs. 4 J-N** illustrate those stages done instead according to an exemplary alternative exemplary method **"B",** all in accordance with examples of the trenched bottom electrode may enable four forms of tunnel junctions based molecular devices. Two approaches (method **A** and method **B**) are discussed in this figure; however, remaining two approaches (method **C** and method **D**) are discussed in FIG. 5 and **FIG. 6****.**

Top row of this figure shows the steps for the two schemes. In a step (**1**) a bottom electrode **330** may be deposited on an insulating substrate **405.** In a step **(2)** photolithography may be used to create window **410** in photoresist layer for creating a trench **320** in the bottom electrode **330.** In a step **(3)** a desired dimensions **415, shown by the rectangle with dash lines,** of the bottom electrode **330** may be removed. The amount of material to be removed **415** to create a trench **320** may be determined based on the type of molecular device elements. Any molecule that can be functionalized to make chemical bonds with the conducting strips is suitable for making TBELMD **300.** Some example molecules are porphyrin, single molecular magnets, organometallic molecules, proteins, alkanes, single ion molecules, etc. In a step **(4)** a bottom electrode surface metal **420** may be oxidized to create the insulator-1 **325.** After this step two methods of molecular devices described as method **A** and method **B.** For method **A,** illustrated by way of example in **FIGs. 4 E-I**, an insulator-2 **315** may be deposited in such a manner that insulator-2 **315** thickness may be lesser than the trench **320** depth. Trench **320** depth may range from ~0.2 nm to 10 nm and will depend on the length and type of targeted molecule. In a step shown in **FIG. 4F** a top conducting metal electrode **310** may be deposited on the top of the insulator-2 **315.** In a step shown in **FIG. 4G** liftoff of photoresist may produce a tunnel junction **425** with the exposed side edges. In a step shown in **FIG. 4H** molecules of interest **430** may create charge and spin conduction bridge between two metal electrodes **305** along the two exposed edges of the tunnel junctions **425.** The zoomed in view of the molecular channel **305** where molecules **430** connect between two metal electrodes **310** and **330** is shown in **FIG. 4I**. The separation between two electrodes **310** and **330** may be governed by the thickness of the insulator-**1325**. This approach may be expected to be useful for the small molecules of ~ 1 nm length scale. For the large molecules of 2-10 nm method **B** may be more useful. Small molecules list may include alkane molecules consisting of 6-20 carbon atoms, porphyrins, inorganic molecules etc. Long molecules may be long chain alkanes, proteins, polymeric chain, DNA etc. For method **B,** a step (**B-1**) focuses on depositing the insulator-2 **315** in such a manner that insulator-2 **315** thickness may be more than the trench **320** depth. Insulator -2 **315** thickness will depend on target molecule length **440.** In a step (**B-2**) a top conducting metal electrode **310** may be deposited on the top of insulator-2 **315.** In a step (**B-3**) photoresist liftoff may be used to produce tunnel junction with the **435** exposed side edges. In a step (**B-4**) molecules of interest may be bridged between two metal electrodes **310** and **330** along the two exposed edges of the tunnel junctions **435.** The zoomed in view of the area where molecule **440** connects between two metal electrodes to form the molecular conduction channels **305** is shown in (**A-5**). The minimum separation between two electrodes **310** and **330** along the junction is governed by the thickness of the insulator-1 **325** and the insulator-2 **315.**

**FIGs. 5 A-H** illustrate, by way of example, side cross-section views of the semiconductor structures formed at each stage of an exemplary alternative exemplary method (referred to as method "**C**") for fabrication of a trenched bottom electrode based molecular devices for the cases when bottom electrode cannot be oxidized to produce insulator-1 **325.** For example, a bottom electrode **330** may be made up of gold, palladium, and platinum like inert metals and semiconductor like gallium arsenide (GaAs), germanium, indium arsenide, and alloyed semiconductors. For this case: in a step shown in **FIG. 5A** a 1^{st} metal strip **330** may be deposited on an insulating substrate **505.** In a step shown in **FIG. 5B** photolithography may be used to produce a window **510** in the photoresist for creating a trench **320** in the 1st strip **330** or bottom electrode. In a step shown in **FIG. 5C** a desired thickness **515** may be removed from the bottom electrode **330,** an amount of material removed may be determined based on the type of molecular device elements. In a step shown in **FIG. 5D** an insulator **325** may be deposited in such a manner that insulator **325** thickness may be more than the trench **515** depth. In a step shown in **FIG. 5E** a top conducting metal electrode **310** may be deposited on the insulator **325.** In a step shown in **FIG. 5F** liftoff photoresist may be used to produce a tunnel junction with the exposed side edges **530.** In a step shown in **FIG. 5G** molecules of interest **535** may be bridged between two metal electrodes in the region **305** along the two exposed edges of the tunnel junctions **530.** The zoomed in view of the area where a molecule **535** may connect between two metal electrodes in the region **305** is shown in **FIG. 5H****.** The separation between two electrodes **310 and 330** may be governed by the thickness of the insulator **325** popping out of the trench **515.**

**FIGs. 6 A-I** illustrate, by way of example, side cross-section views of the components of TBELMD **300** formed at each stage of an exemplary alternative exemplary method (referred to as method "**D**") for fabrication of trenched bottom electrode based molecular devices for the cases when bottom electrode **330** cannot be oxidized to produce insulator-1 **325.** Instead, insulator-1 **325** may be deposited by attaching molecular monolayer via self-assembly. For this case: in a step shown in **FIG. 6A** a first electrode **330** may be deposited on an insulating substrate **605.** In a step shown in **FIG. 6B** photolithography may be used to create window **610** in photoresist for creating a trench in the first electrode **330.** In a step shown in **FIG. 6C** a desired thickness **615** of the first electrode **330** may be removed, an amount of material removed may be determined by the type of molecular device elements. In a step shown in **FIG. 6D** small molecules may self-assemble to create insulator-1 **620.** In a step shown in **FIG. 6E** a second insulator **625** may be deposited in such a manner that insulator thickness may be more than the trench depth. In a step shown in **FIG. 6F** a second conducting metal electrode **630** may be deposited on the insulator. In a step shown in **FIG. 6G** liftoff of photoresist may be used to produce tunnel junction with the exposed side edges **635.** In a step shown in **FIG. 6H** molecules of interest **640** may be bridged between two metal electrodes along the two exposed edges of the tunnel junctions. The zoomed in view of the regions where molecule **640** connects between two metal electrodes is shown in **FIG. 6I**. The separation between two electrodes may be governed by the thickness of the **625**-insulator popping out of the trench.

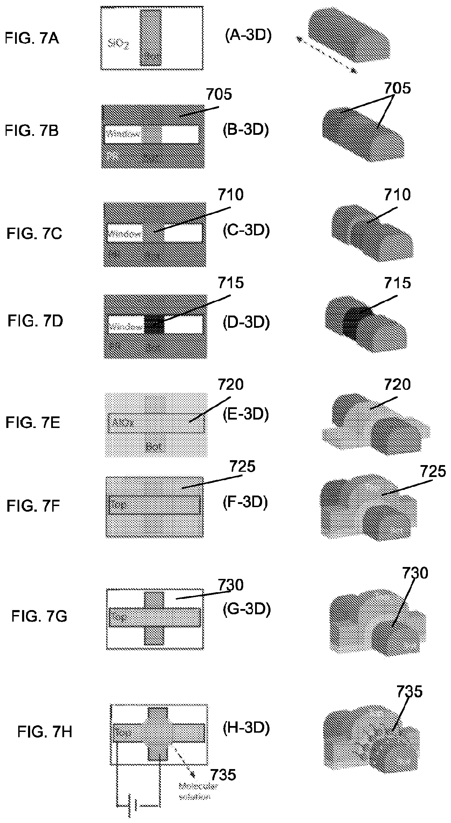

**FIG. 7** **A** to **H** illustrate, by way of example, various top and side perspective views of the components of TBELMD formed at each stage of an exemplary process flow for creating the exemplary trenched bottom electrode based molecular devices.
This process flow is for "**A**" method as discussed in **FIG. 4****.** For other three methods **B, C, D** shown in **FIG. 4****,** **FIG. 5****,** **FIG. 6****,** respectively, the same process flow will be applicable, but difference will be in the insulator growth step after etching. Top view and corresponding 3D view of the process flow for creating the trench based molecular devices are shown. In a step (**FIG. 7** **A**) a first conducting strip may be deposited with tapered edges. Tapered sides of the first electrode may ensure that any anomaly on the edge do not damage the insulators. In a step (**FIG. 7** **B**) photolithography may be conducted to create a window in the photoresist. The window in photoresist may be crucial for matching the lateral dimension of at least one insulator and at least one metal strip that may be deposited on the first metal strip for completing tunnel junction. It is noteworthy that in the 3D view, the photoresist protected region of the first metal strip is shown by the dark area **705** to simplify the viewing of different materials. In a step (**FIG. 7C**) a trench in the first metal strip **710** may be formed by etching away material from the top of the first metal strip from unprotected region. Trench depth may be controlled to facilitate the bridging a desired molecule between the first and the second metal strips. In a step (**FIG. 7D**) the trench region the first insulator (Insulator-1) **715** may be created by the plasma oxidation of the first metal strip or by adding a monolayer of insulating molecules by the self-assembly process. In a step (**FIG. 7E**) a second insulator (insulator-2) **720** may be deposited on the top of the insulator-1 surface. Insulator-2 may be alumina (AlOx), magnesium oxide (MgO), silicon di oxide, silicon nitride etc. In a step (**FIG. 7F**) a second metal strip **725** was deposited on the top of at least one insulator. In a step (**FIG. 7G**) photoresist layer and the materials sitting on the photoresist may be removed by the liftoff step. Liftoff may result in the tunnel junction testbed with the exposed side edges **730.** In a step (**FIG. 7H**) finally a junction is submerged in the molecular solution to connect molecular bridges **735** between the first and the second metal strip.

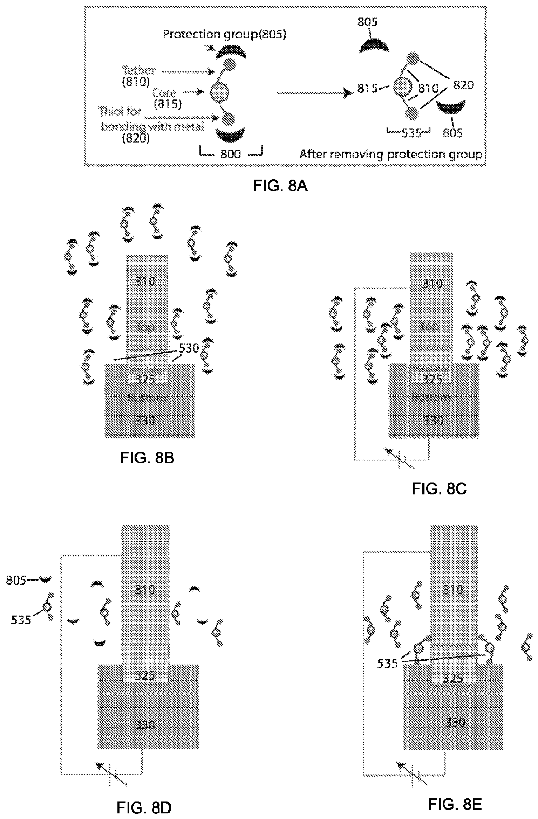

**FIGs. 8 A-E** illustrate side cross-section views of the before, during, and after states of exemplary molecules for the exemplary molecular device during the exemplary method of attaching molecules shown in **FIG. 7** for the present molecular device, where **FIG. 8A** illustrates molecules **800** before and after protection group **805** to release thiol groups **820,** **FIG. 8B** illustrate molecules randomly floating around tunnel junction after submerging the tunnel junction with expose side edges **530,** **FIG. 8C** illustrate electrophoretically concentrating molecules **800** near a junction, **FIG. 8D** **illustrate** and removing protection group from thiol to facilitate metal-molecule chemical bonding **FIG. 8E** illustrate formation of thio-metal chemical bonding to create molecular bridges **535.** **FIG. 8** illustrates the structure of a molecule to be incorporated in the molecular device and method of attaching them between the first and second metal strip. In a step (**FIG. 8A**) molecules to be used for the TBELMD may have a core **815** with switchable quantum state, tethers **810** to provide sufficient length to overall molecule, thiol like functional groups to form chemical bonding with metal electrodes, and acetate like protection groups **805** to inhibit undesirable interaction of thiol functional groups **820** with other molecules. This molecular core **815** may allow the quantum state of a molecule to become the part of a TBELMD. The molecule's core may possess controllable and novel magnetic, optical, and transport characteristics. To harness a molecule's core attributes in the device at least two tethers **810** may be attached to the molecule core. Adding tethers to core may make an overall molecule length suitable for bridging them between the two metal stripes **310** and **330.** However, a tether **810** itself may be unable to make chemical bond with the metal layers **310** and **330.** Hence, it is more pertinent that each tether **810** should end with the thiol functional group **805** or a suitable anchoring group to establish chemical bonding with the metal strips. For example, thiol functional group may form strong covalent bond with the ferromagnetic metal layer. However, in some cases thiol functional group **805** may interact with molecule core **815** or with other thiol functional groups to form di sulfide bonds. To prevent undesirable interactions of a thiol functional group they may be protected by easily removable protective functional group **805.** Protective functional group **805** may be removed by electrochemical method or by adding NaOH like base. The method of attaching a molecule between the first **330** and second **310** metal strip may be accomplished as shown in the cross-sectional view of the device. In a step (**FIG. 8B**) a tunnel junction with exposed side edges **530** may be submerged in the molecular solution with sufficient concentration. In a step (**FIG. 8C**) an electric field may be applied to accumulate molecules **800** near the junction area. Prior patent describe the method of utilizing electric field to mobilizing the molecules between the metal electrodes (Heller, Gilbert et al. 2004, US 6778853 B1). In a step (**FIG. 8D**) thiol or other anchoring groups **820** of the molecules may be freed from the protective chemical groups **805** by adding NaOH or by applying the suitable voltage on the first and second metal strips **330** and **310.** The details of different protective groups and methods of deprotections may be described in the patent by (Freeman and Pisharody 2005, WO 2004061416 A3). In a step (**FIG. 8E**) molecules with free thiol or similar anchoring group **535** bond with the metal leads to establish conduction bridges. **FIG. 8** also represent the method of attaching molecules for the other variations of TBELMD shown in **FIG 4-6****.**

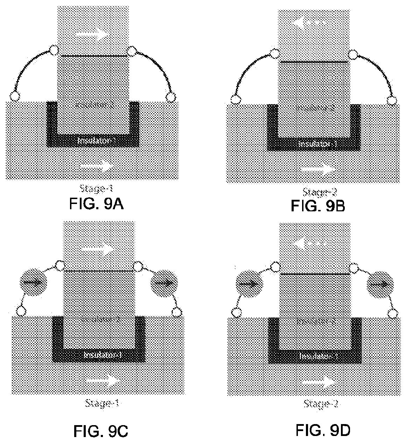

**FIGs. 9 A-D** illustrates a cross sectional view along a bottom layer of an exemplary TBELMD based molecular spin valve device during the mechanism of a two terminal TBELMD serving as an exemplary spin valve type memory device, where **FIG. 9A** and **FIG. 9B** illustrate alkane like simple molecular device elements, and **FIG. 9C** and **FIG. 9D** show molecule with tunable quantum states as shown in **FIG. 9A****.** The disclosed molecular device method may produce high magneto resistance ratio for application in magnetic random-access memory. The use of simple alkane molecules to high functionality molecules with tunable quantum state may be possible. Simple alkane molecules may be connected between the two ferromagnetic metal strips. Due to the low spin orbit coupling and Zeeman splitting the alkane molecule may serve as superior spin pathways than that of insulator-1 and insulator -2. Also, resistance of the short, chain alkanes may be much smaller and may require less operational power. Alkanes molecules may be also virtually defect free and hence enable long spin coherence length and time. In addition, the proposed molecular device approach may allow the deposition of the first and second metal strip made up of single or multiple layers of materials. The anisotropy and magnetic coercivity may be controlled to switch the direction of magnetization of the second metal strip. The magnetization of the first metal strip may be pinned. The molecular device discussed herein may demonstrate bistable resistance state-that is basis for utilizing such devices as the memory units. First and second metal strip may also utilize CoFeB magnetic materials that will enable direction of the magnetic moments to be perpendicular to the plane of the metal strips. In the first stage (**FIG. 9A**) by the application of external magnetic field the magnetization of the second metal strip may be aligned parallel to the direction of the magnetization of the first metal strip. In this state the molecular device may be in the lowest current state. In the second stage (**FIG. 9B**) similarly, the application of external magnetic field may set the magnetization of the first and the second metal strips in the opposite direction to set the device in the high resistance state. The ratio of difference between high and low resistance values to the high resistance may produce characteristics magneto resistance ratio for a molecule.

Replacing the simple alkane molecules with a molecule that possess a switchable molecular core may exhibit multiple magneto resistance ratio. The application of light, heat, and magnetic field may selectively change the quantum state of the molecular core. For every quantum state at the core the direction of the magnetization of the second metal strip may be set parallel (**FIG. 9C****)** and antiparallel **(****FIG. 9D****)** to the direction of magnetization of the first metal strip. The magneto resistance ratio, calculated by taking the ratio of the difference of resistance in the low and high state to high resistance of the device, may be different for each quantum state of the core of the molecule. The application of light, heat, and magnetic field to maneuver the molecular quantum state may be analogous to the utilization of gate electrode in the field effect transistors.

Two terminal TBELMD involving small paramagnetic molecules can produce spin based solar cell. The prior work discussed in **FIG. 2** leaded to solar cell effects (P. Tyagi, "Spin Photovoltaic Effect on Molecule Coupled Ferromagnetic Films of a Magnetic Tunnel Junction," ASME International Mechanical Engineering Congress and Exposition, vol. 6B: Energy, p. V06BT07A039, 2013.). However, prior molecular device fabrication approaches shown in **FIG. 2** were incapable of producing large area molecular devices due to limitation on the insulator of magnetic tunnel junction. In the prior work thickness of insulator between two ferromagnetic films had to be smaller than the molecule length. The typical desirable molecule length is 1-3 nm range. Due to that limitation prior molecular devices become fragile when area was increased. The TBELMD enables the utilization of paramagnetic molecules promising for producing solar cell effect without imposing any limit on the thickness of insulator between two ferromagnetic electrodes. TBELMD based solar cell typically utilize two 5- 20 nm thick ferromagnetic layers of significantly different magnetic coercivity. The role of paramagnetic molecules is to strongly couple the wave functions of the two ferromagnetic metal electrodes in a TBELMD. Under strong coupling effect TBELMD produces new magnetic properties similar to those discussed in the **FIG. 2** regarding prior molecular device work by the inventor. The molecule mediated exchange coupling result into a light radiation sensitive magnetic layer in a TBELMD. This radiation sensitive TBELMD emerges due to high degree of spin density exchange between the two ferromagnetic electrodes that produces a resultant diode like behavior. This phenomenon is akin to p-n junction formation in a regular solar cell. However, in a TBELMD spin up and spin down atoms and electrons play the roles of the positive and negative ions and electrons in a charge-based p-n junction solar cell. This molecule impacted area absorb light radiation. While diode like characteristics is associated with the TBELMD's ability to move light radiation generated spin up and spin down electrons in the opposite direction. Hence, under light radiation this TBELMD's diode characteristic enables the separation of spin up and spin down electron to produce a net current flow of spins in the TBELMD. The inventor's prior work illustrates the science behind the functioning of spin based solar cell (P. Tyagi, "Spin Photovoltaic Effect on Molecule Coupled Ferromagnetic Films of a Magnetic Tunnel Junction," ASME International Mechanical Engineering Congress and Exposition, vol. 6B: Energy, p. V06BT07A039, 2013.). TBELMD approach provides a robust method of producing spin based solar cell.

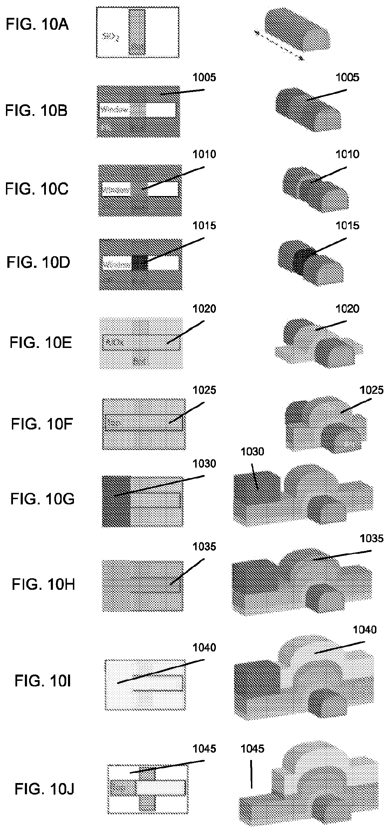

**FIG. 10** **A** to **J** illustrate, by way of example, various top and side perspective views of an exemplary three terminal TBELMD where a third metal electrode serves as a Gate, at each stage of an exemplary process flow for creating. **FIG. 10** illustrates an exemplary method of producing field effect based molecular device. The ability to maneuver the molecular quantum state with the field effect may require the presence of a gate insulator and Gate metal strip in addition to the first and second metal strips. Molecules may make simultaneous contact with the first, second, and the gate electrode or third metal strip.

The first and the second metal strip in the two terminal tunnel junction based molecular device may be analogous to the source and drain contacts present in the conventional CMOS type field effect devices. With reference to **FIG. 7****,** design and fabrication of the proposed field effect molecular device may be based on the design and fabrication of the two-terminal trenched first electrode based molecular device disclosed in the **FIG. 7****.** With reference to **FIG. 7****,** the **FIG. 10****(A - E)** steps are exactly same as discussed in the description of **FIG. 7****(A-E).** To produce the gate dielectric layer and the third metal strip the photolithography window **1005** that may be used for making the trench **1010,** depositing insulator-1 **1015,** insulator-2 **1020,** and the second metal strip **1025** may have been utilized. An advantageous aspect of employing the first photoresist window may be that the lateral dimensions of the gate dielectric and the third metal strip may be the same as that of metal strip 2. Panels **FIG. 10A - F** and corresponding 3D views show the process steps up to the deposition of the second metal strip, and before the liftoff of the photoresist. Panel **FIG. 10G** shows the method of covering one side the second metal strip **1025** and the first photoresist layer with a second layer of photoresist **1030.** Panel **FIG. 10H** shows the deposition of gate dielectric film or the third insulator **1035** on the top of the second metal strip **1025.** Panel **FIG. 101** and corresponding 3D view shows the deposition of the third metal strip or the gate electrode **1040** before the liftoff step. Panel **FIG. 10J** shows the top view and 3D view of the complete tunnel junction with the third metal strip **1040.** Panel **FIG. 10J** shows liftoff photoresist and protection on the left side of the ferromagnetic electrode to produce tunnel junction **1045** for spin field effect transistor (SPINFET). This form of molecular device was realized after the liftoff of the two photoresist layers and materials sitting on it. With reference to **FIG. 11****,** the description of the required form of the molecule and the method of bonding the same molecule to the three metal strips is discussed in the **FIG. 11****.**

**FIGs. 11 A-F** illustrate top, side perspective and cross sectional views of a required exemplary form of the TBELMD with three terminals and required exemplary form of the molecule and the method of bonding the same molecule to the three metal strips to form the field effect based molecular devices, where the top view **(****FIG. 11 A**) shows the submerging of the junction into a molecular solution for chemically bonding of the molecule with the metal strips that may, side perspective view **(****FIG. 11B****)** shows the 3D side view of the junction, and cross sectional view **(****FIG. 11C****)** shows electrophoretically concentrated molecules near a junction, **(****FIG. 11D****)** shows selective removal of protection group-1 **1120** to connect a molecule to source and drain metals, **(****FIG. 11E****)** shows bonding of **1115** with the source and drain metal electrodes, **(****FIG.11F****) shows** selective removal of protection group-2 **1135** by applying a bias on Gate electrode, **(****FIG. 11F****)** shows a long tether **1125** getting attached to a Gate electrode via anchoring group **1130.** **FIG.11C** also shows the desired form for a molecule that may be bonded to the three metal strips. A target molecule may possess at least two relatively short tethers **1110** coming out of the core **1105** of the molecule and terminated with thiol like anchoring group **1115.** Relatively short tethers are only capable of bridging the insulating gap **1020** and **1015** between bottom electrode **1010**(first) and middle metal (second) electrode **1025.** Short tethers **1110** will not be able to simultaneously bond between bottom electrode **1005** and the top metal Gate electrodes **1035.** Short tethers **1110** may form a molecular bridge between the bottom **1005** and middle ferromagnetic electrodes **1025.** The thiol anchoring terminal **1115** may be protected by a protective group that is referred as protective group-1 **1120.** Upon the selective removal of protective group-1 **1120** thiol terminal group **1115** may be freed to chemically bond with the first metal strip **1005** and second metal strip**1025**. The target molecule may also possess at least one long tether **1125** coming out of its core**1105**. From core **1105** is also connected to at least one long tether molecule **1125.** The long tether **1125** is terminated with a thiol like terminal group **1130** to specifically bond with the third metal strip or the gate electrode **1035.** The length of long tether may depend on the thickness of the second metal strip **1025** and the thickness of insulator-3 **1030.** The terminal group of the long tether **1130** may be protected by protection group-2 **1135** to avoid undesired interaction of the terminal group **1130** with the core **1105** and with other terminal group **1105** to form disulfide type bonds. However, protection group -1 **1120** and protection group-2 **1135** may be designed to remove under different conditions to allow selective interactions.

Alternatively, one may attach different thiol like anchoring groups at the end of each tethers **1110** and **1125,** but protect them by the same protection group. Cross sectional view **FIG**. **11C** shows the tunnel junction with the gate dielectric (insulator-3) **1030** and the third metal strip (gate metal electrode) **1035.** **FIG**. **11C**also shows the mechanism of driving desired molecules close to the junction area where metal electrodes **1005** and **1025** are physically separated by insulator-1 **1015** and insulator-2 **1020**. An electric field may be created near the junction of the first 1005 and second **1025** metal strips. The application of electric field may electrophoretically drive the molecules towards the junction and increases the molecular concentration in the junction vicinity-even when a diluted molecular solution is used. Details of molecule mobilization are discussed in the prior patent (Heller, Gilbert et al. 2004, US 6778853 B1) where the use of electric field may be used for driving nanostructures. Panel **FIG**. **11E** shows the process of selectively removing protection group-1 **1120.** To enable metal-molecule bonding the first protection group **1120** may selectively be removed to free up the thiol like terminal groups **1115** present at the end of short tethers **1110**. Adding, NaOH into molecular solution and the application of suitable voltage on the metal strips may be highly effective in removing the protection group **1120.** One can also utilize NH₄OH and KOH to remove protection group. Panel **FIG. 11E** described the bridging of the molecule between the first and the second metal strips **1005** and **1025**. The thiol like terminal group **1130** at the end of the long tether **1125** may still be protected. Panel **FIG. 11** **F** describes the process of connecting the molecule to the gate electrode or the third metal strip **1035**. The thiol like terminal group **1130** present at the end of the long tethers **1125** may be freed by selectively removing the protection group-2 **1135.** The discussion about various protection groups and several approaches to remove them controllably is discussed in the prior patent (Freeman and Pisharody 2005, WO 2004061416 A3) and the references therein (e.g. P.G. Wuts: Protective Groups in Organic Synthesis, 5th ed. (Wiley 2006)). The free thiol like terminal group **1130** may be bonded to the third metal strip **1035** by applying suitable voltage on the third metal strip. After this process a molecule may be connected to the three metal strips of the tunnel junction and ready to be used as a field effect based molecular device.

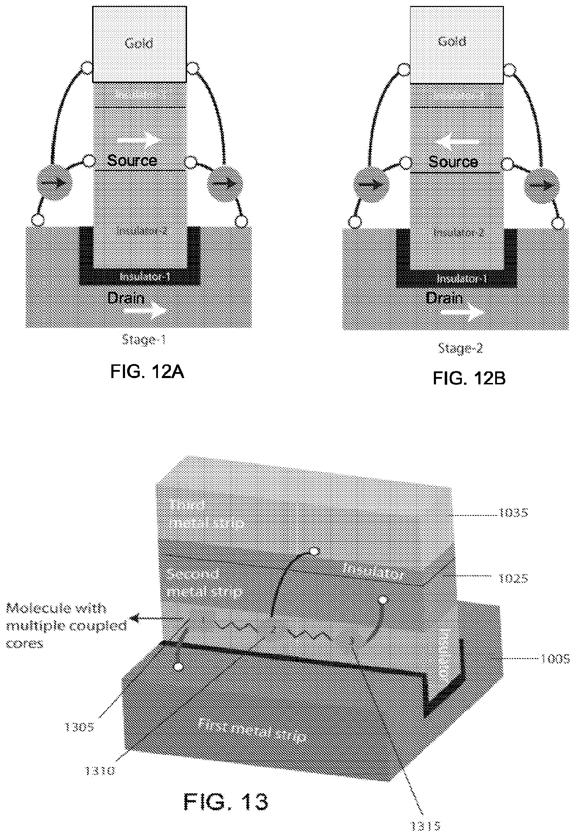

**FIGs. 12** **A** and **B** illustrate cross sectional views of an exemplary three terminal molecular device serving as a logic device, where **FIG. 12A** shows stage-1, and **FIG. 12B** shows stage-2. A molecular device with three terminals may work as a field effect transistor. For this device, a molecule may be specially designed to possess a third tether. This third tether may be chemically bonded to the top Gate electrode as shown in panel **FIG. 12** **A.** This molecular device may allow an application of electric field via the gate electrode to maneuver the molecular energy levels. The gate electrode may switch the quantum state of the molecule. For every molecular quantum state current-voltage characteristics may be recorded. In this molecular device the first and the second metal electrode may work as source and drain. The source and drain or the first and second metal strip may be made up of ferromagnetic materials. The magnetization of the first ferromagnetic layer may be pinned or fixed. However, the magnetization of the second ferromagnet may be free to rotate with the help of external magnetic field. In this TBELMD configuration shown in **FIG. 12****,** one ferromagnetic film will serve as a source (e.g., Source electrode) while other ferromagnetic film will serve as a sink of spin or (e.g., Drain electrode). Spin transport via molecule is in the low resistance state when the magnetization of the source and drain may be parallel to each other. On the other hand, the spin transport via molecule may be in the high resistance state when the magnetization of the source and drain is aligned in the opposite direction. These high and low resistance states may be impacted by the molecular quantum state participating in the spin transport. The gate electrode may enable the manipulation of the molecular quantum state and yielding a spin-based field effect transistor for molecular logic devices. Since the molecular channels are exposed to the open environment the device structure disclosed here may also serve as the spin-based field effect transistor, chemical sensor, biochemical sensor, and energy sensor etc.

For the TBELMD shown in **FIG 12****,** the gate metal electrode can flip the spin direction of the electron present in the molecular channel by Rashba like effect. The spin up and spin down states of the electron in the molecular channel will result in the TBELMD's on and off states.

The disclosed TBELMD in **FIG. 12** with three terminals may function like a variable molecular state spin field effect transistor-based logic device. In this case the ferromagnetic bottom metal electrode and the ferromagnetic middle metal layers are connected to a molecule that can change its spin state. Here, ferromagnetic metals will serve as a source and detector (Drain) for the spin of the electrons. However, gate electrode will change the magnitude of the spin state of the molecule. Many device states will result due to gate tunable molecular quantum states. For example a Mn12 like single molecular magnet molecule can acquire spin states from +10, +9, +8, +7, +6, +5,+4,+3,+1, 0, -1, -2,-3,-4,-5,-6,-7,-8,-9,-10. Mn12 molecule can be employed in a TBELMD shown in **FIG**. 3. Controllably switching the molecular quantum states for Mn12 in those 20 states will produce 20 device states that can be used for the logic operation in a single TBELMD.

Three terminal TBELMD shown in **FIG.12** can work as a testbed for quantum computation devices. The disclosed TBELMD will serve as a highly robust testbed to forming the quantum computation device with promising molecules. The single ion molecules (Y.-S. Ding, Y.-F. Deng, and Y.-Z. Zheng, "The rise of single-ion magnets as spin qubits," Magnetochemistry, vol. 2, p. 40, 2016.) and single molecular magnets (E. Coronado and A. J. Epsetin, "Molecular spintronics and quantum computing," J. Mater. Chem., vol. 19, pp. 1670-1671, 2009.) have been projected for the quantum computation. However, there exists a technological gap for developing the method of integrating molecule into a robust and mass producible device for quantum computation. The TBELMD's gate metal electrode may electrically drive nuclear spin resonance in single molecular magnet to enable quantum computation operation. In TBELMD approach a molecule is interfaced to the source and drain terminals of the TBELMD. The electric field from the gate electrode of the TBELMD can be easily focused and shielded in the small volume to affect the molecular device states.

TBELMD can simultaneously function as a logic and memory device to give the effect of two in one device. The three terminal TBELMD shown in **FIG. 12** can simultaneously function in dual modes -as a logic device and as a memory device. To serve as inbuilt memory device the bottom ferromagnetic electrode may have fixed or pinned magnetization. On the other hand, the middle ferromagnetic metal layer may be soft and free to rotate magnetic moment. Aligning the magnetic moment of the two ferromagnetic layers parallel to each other will produce high current via the molecule and will correspond to binary 1 or ON state. Aligning the magnetic moments of the two ferromagnetic electrodes antiparallel to each other will produce low current state and this device state will correspond to binary 0 or OFF state. In each of the condition, when two ferromagnetic layers will be parallel or antiparallel to each other, the gate electrode of TBELMD can influence the transport via molecule to enable the separate ON and OFF states for the logic operation. Hence, gate will enable ON and OFF states when TBELMD have parallel magnetic moments of the magnetic layers. Gate will also enable ON and OFF states when TBELMD have antiparallel magnetic moment of the magnetic layers. This dual function TBELMD will have inbuilt magnetic random-access memory.

TBELMD shown in **FIG. 12** may function as a three-terminal charge-based computer logic device. The disclosed TBELMD with three metallic terminals may function like a classic complementary metal oxide semiconductor (CMOS) computer logic device. However, this TBELMD will be based on the charge transport via the molecular channel. In this case, all the three metal electrodes are connected to each molecule. These three metal electrodes will be made up of nonmagnetic conducting metals or highly conducting semiconductors. Nonmagnetic metals and conducting semiconductor may be made up of gold, silver, copper, highly doped silicon, titanium, tungsten etc. The trenched bottom electrode and the middle metallic electrode will serve as the source and drain electrodes. The top metal lead will serve as the Gate electrode to electrostatically maneuver the molecular energy levels. Controlling the molecular energy level via gate electrode set a TBELMD in the "ON" and "OFF" state. The conduction between source and drain will occur via quantum tunneling

**FIG. 13** illustrates a side perspective view of an exemplary three terminal TBELMD utilizing multicore molecule for producing novel computer devices, energy sensors, and chemical sensors. This approach may provide a practical route to make unimolecular structure-based devices. Complex molecules with three parts **1305, 1310,** and **1315** may serve as source, drain, and gate component of unimolecular field effect device. In this device TBELMD may utilize nonmagnetic metal electrodes or strips **1005, 1025,** and **1035** to focus on charge property of electron. The in depth discussion about the description and mechanism of unimolecular device element is discussed in the prior patent (Ellenbogen 2002, US 6339227 B1). This prior patent describes the design of a big unimolecular comprising of at least three parts. The three parts of an unimolecular serve the role of source, drain and gate electrodes (Ellenbogen 2002, US 6339227 B1). However, in the prior patent no details about the method of forming molecular device were discussed. According to best of our knowledge no experimental method has been successful in producing unimolecular based devices. TBELMD invention provides a viable approach to fabricate unimolecular based devices.

This TBELMD approach may also provide a route to design devices where a molecule may respond to various stimuli. A molecule may have multiple cores that may respond to radio frequency (RF) energy, light, heat, and magnetic field to enable multiple controlling factors to attain multiple quantum states. For example, for the three-core molecule shown in **FIG. 13** the first core **1305** of the molecule may respond to light radiation, the second core **1310** may respond to electric field, and the third core **1315** may respond to thermal energy. Alternatively, each of the three cores of the molecules shown in **FIG. 13** may respond to radiations of different wavelengths to serve as an energy detector.

This TBELMD approach may also provide a method to make multi-chemical sensor. One may functionalize the different cores of a molecule to specifically interact with a molecule of interest. For instance, the three cores of the molecules **1305, 1310,** and **1315** shown in **FIG. 13** may be functionalized to interact with three distinct chemicals and register the interaction in the form or charge and spin flow in the TBELMD. This TBELMD approach may also do simultaneous detection of multiple biological and defense specific chemicals. TBELMD may target chemicals such as chlorine, hydrogen sulfide, ammonia, hydrogen cyanide, sarin, phosphine, arsine, nitrogen dioxide, and carbon monoxide. On the other hand, TBELMD based biomolecular sensor may be designed to perform electrochemistry-based sensing and field effect-based sensing. For electrochemical sensing of biomolecules at least one of the two metal electrodes **1005** and **1025** of the TBELMD should employ gold or platinum like nobel metals. These metals may allow TBELMD to exchange electrons with a target molecule or molecule to be detected. Utilization of nobel metals can enable TBELMD to detect chemical such as dopamine, serotonin, ascorbic acid, and glucose etc. TBELMD invention can also utilizes field effect-based sensing to detect the molecules of interest. As a field effect sensor, molecule used in TBELMD may function like a field effect sensor. If a foreign biomolecule or a threat chemical comes close to TBELMD, then current passing through TBELMD's molecule may change. The change in the TBELMD's molecule current due to foreign molecule may help in the identification and quantification. For these application TBELMD molecules, which are bridged between two metal films, serve as a field effect sensor or molecular sensor.

A method comprises placing molecular device elements or molecular sensor in the open area along the magnetic tunnel junction edges to facilitate the interaction with external molecules. In such case electron's spin will be instrumental in chemical sensing. A target chemical or biomolecule interact with the molecular device element or molecular sensor and hence influence the spin transport via the molecular sensor. The molecular device elements can be specifically designed to only interact with the intended chemical or biomolecules. TBELMD allow the use of spin transport via molecular sensor to detect DNA nucleotides. For this task ferromagnetic electrodes are functionalized with the molecular sensor that captures DNA nucleotides via hydrogen bonds. Then identities of the individual nucleotides are expressed by the change in spin current due to single -molecule bonding events. Prior reference that accomplishes such task by an alternative device fabricated through different route is discussed in the reference (P. Pang, B. A. Ashcroft, W. Song, P. Zhang, S. Biswas, Q. Qing, et al., "Fixed-gap tunnel junction for reading DNA nucleotides," ACS-NANO, vol. 8, pp. 11994-12003, 2014. However, prior work was unable to utilize molecular sensor whose length is smaller than the thickness of the insulating barrier between the first and second metal layers. Hence, prior work has been limited by the limited types of molecules and limited types of metallic leads that can be used for chemical sensing. The disclosed invention also highlight focuses on TBELMD capability to serve as biochemical sensor by utilizing spin property of electron.

In **FIG. 13** a three-core molecule is proposed to make bond with the three metal electrodes. The first **1305** and third core **1315** of the molecules may make direct contact with the ferromagnetic electrode to produce two ferromagnet-molecule interface regions. Each of these two interfaces may have different switching fields with respect to each other and also with regards to bulk regions of the two ferromagnets. With this TBELMD arrangement at least two device states may be realized to perform memory and logic device operations. In addition, gate electrode may be chemically bonded to the middle section of the molecule to electrostatically maneuver the molecular energy levels to produce a field effect-based spin-interface device.

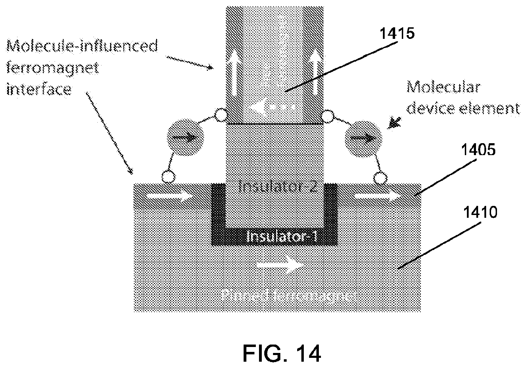

The TBELMD approach may also provide a practical method of making Spinterface devices as illustrated in **FIG. 14****.** The properties of TBELMD based Spinterface devices may be governed by the molecule-ferromagnet interfaces. Spinterface devices may focus on specific properties of the molecule-ferromagnetic electrode interfaces to obtain multiple device states for logic and memory operations. A complex molecule with multiple centers may produce spin interface devices. Direct interaction between the specific section of a molecule and ferromagnetic metal may induce strong hybridization. Due to this strong hybridization interfacial regions **1405** may acquire different magnetic anisotropy and hardness as compared to the bulk body **1410** and **1415** of the ferromagnetic electrodes. As a result, the magnetic field required to switch the direction of magnetic moments in the molecule-ferromagnet interface regions may be much different than that required for the bulk ferromagnet. **FIG. 14** illustrates a cross sectional view of an exemplary two terminal TBELMD based interface device. This figure shows that at the interfaces where molecules chemically bond with the ferromagnetic electrodes new regions **1405** may appear. These new regions possess significantly different magnetic properties than that possessed by the bulk of the bottom **1410** and top ferromagnetic electrode **1415.** As a result, the magnetic hysteresis behavior, the magnetic field at which a magnetic material switch direction, become different for the interface regions **1405** as compared to bulk ferromagnets (**1415** and **1410** regions).

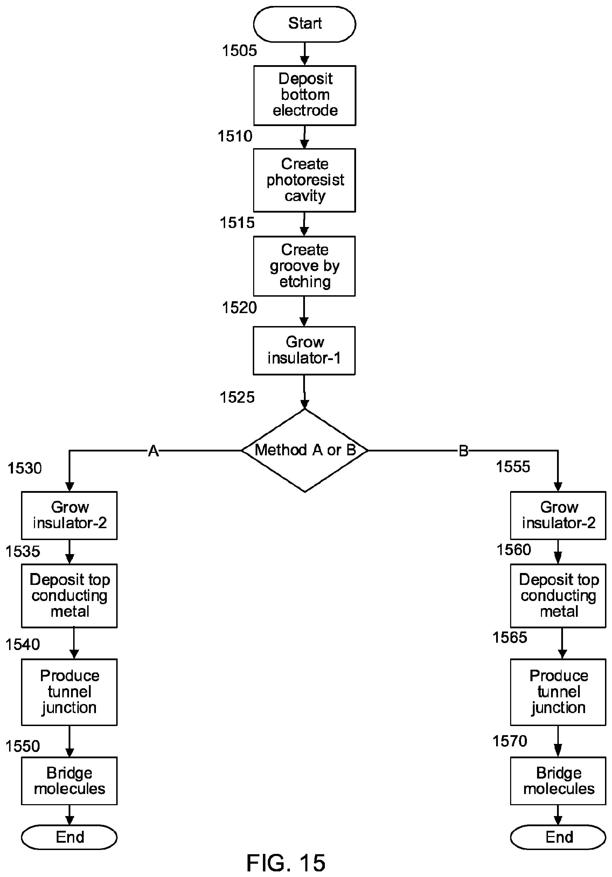

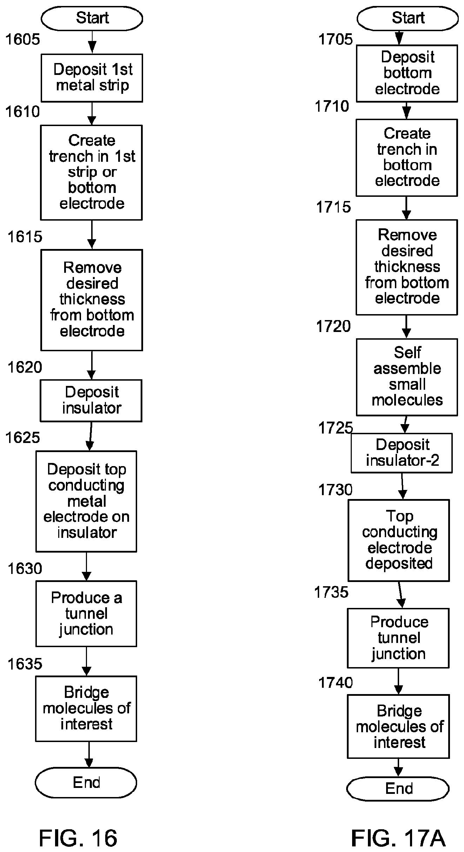

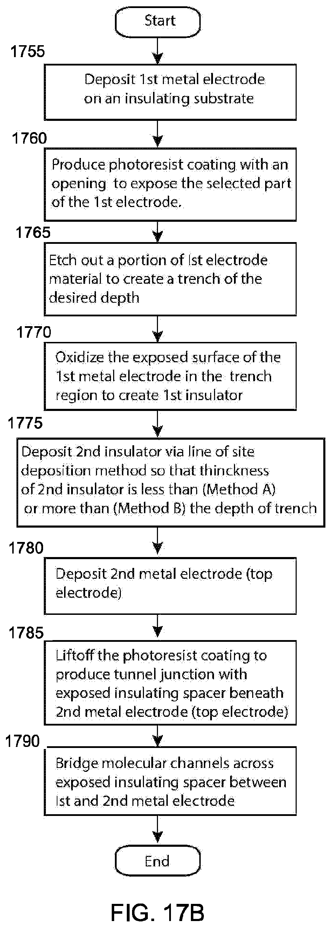

**FIG. 15** illustrates a flowchart of a method for fabricating an exemplary trenched bottom metal electrode and liftoff based molecular device TBELMD. A trenched bottom electrode may enable four forms of tunnel junctions based molecular devices. Two approaches (method **A** and method **B**) are discussed in this figure; however, remaining two approaches (method **C** and method **D**) are discussed in **FIG. 16** and **FIG. 17****.** In reference to **FIGs. 4****,** **5** and **6****,** **FIG. 14** corresponds to the methods in **FIG. 4****,** **FIG. 15** corresponds to **FIG. 5****,** and **FIG. 16** corresponds to **FIG. 6****.** In reference to this figure, in a step **1505** a bottom electrode is deposited on an insulating substrate. In a step **1510** photolithography may be used to create window in photoresist layer for creating a trench in the bottom electrode. In a step **1515** a desired thickness may be removed from bottom electrode, where an amount of material removed will be determined based on the type of molecular device elements. In a step **1520** the bottom electrode metal may be oxidized to create an insulator-1. In a step **1525** a choice may be made from two possible options of methods **(A)** or **(B).**

For small molecules option method, **A** may be more useful. For method **A,** in a step **1530** an insulator-2 may be deposited in such a manner that insulator-2 thickness may be lesser than the trench depth. In a step **1535** a top conducting metal electrode may be deposited on the top of the insulator-2. In a step **1540** liftoff of photoresist may produce a tunnel junction with the exposed side edges. In a step **1550** molecules of interest may be bridged between two metal electrodes along the two exposed edges of the tunnel junctions.

For the large molecules, the option method **B** may be more useful. For method **B,** step **1555** focuses on depositing the insulator-2 in such a manner that insulator-2 thickness may be more than the trench depth. In a step **1560** a top conducting metal electrode may be deposited on the top of insulator-2. In a step **1565** photoresist liftoff may be used to produce tunnel junction with the exposed side edges. In a step **1570** molecules of interest may be bridged between two metal electrodes along the two exposed edges of the tunnel junctions.

**FIG. 16** illustrates a flow chart of a method for forming exemplary molecular device (referred to as method "**C**") for fabrication of a trenched bottom electrode based molecular devices for the cases when bottom electrode cannot be oxidized to produce insulator-1. A method **C** may be useful for fabrication of a trenched bottom electrode based molecular devices for the cases when bottom electrode may not be oxidized to produce insulator-1. For example, a bottom electrode may be made up of gold and platinum like inert metals and semiconductor like gallium arsenide (GaAs). For this case: in a step **1605** a first metal strip may be deposited on an insulating substrate. In a step **1610** photolithography may be used to produce a window in the photoresist for creating a trench in the first strip or bottom electrode. In a step **1615** a desired thickness may be removed from the bottom electrode, an amount of material removed may be determined based on the type of molecular device elements. In a step **1620** an insulator may be deposited in such a manner that insulator thickness may be more than the trench depth. In a step **1625** a top conducting metal electrode may be deposited on the insulator. In a step **1630** liftoff photoresist may be used to produce a tunnel junction with the exposed side edges.
In a step **1635** molecules of interest may be bridged between two metal electrodes along the two exposed edges of the tunnel junctions.

**FIG. 17A** illustrates a flow chart of a method for forming semiconductor structures (referred to as method "**D**") for fabrication of trenched bottom electrode based molecular devices for the cases when bottom electrode cannot be oxidized to produce insulator 1. An insulator-1 however may be deposited by attaching very small molecules via molecular self-assembly. In a step **1705** a bottom electrode is deposited on an insulating substrate. In a step **1710** photolithography creates a window in photoresist for creating a trench in the bottom electrode. In a step **1715** a desired thickness of the bottom electrode is removed, an amount of material removed will be determined by the type of molecular device elements. In a step **1720** small molecules are self-assembled to create a first insulator. In a step **1725** an insulator-2 is deposited in such a manner that insulator thickness may be more than the trench depth. In a step **1730** a top conducting metal electrode is deposited on the insulator. In a step **1735** liftoff of photoresist produces a tunnel junction with the exposed side edges. In a step **1740** molecules of interest are bridged between two metal electrodes along the two exposed edges of the tunnel junctions.

**FIG. 17B** illustrates a flow chart of a process where the 1st metal electrode will be oxidized to produce the 1st insulator, in accordance with an embodiment of the present invention. Hence, the 1st metal electrode may be made up of a metal that produces an insulator after reacting with oxygen. Exemplary metals are Titanium, Tantalum, Nickel, etc. In a step **1755,** a first conducting strip may be deposited with tapered edges. Tapered sides of the first electrode may ensure that any anomaly on edge does not damage the insulators. In a step **1760,** photolithography may be conducted to create a window in the photoresist. The window in photoresist may be crucial for matching the lateral dimension of at least one insulator and at least one metal strip that may be deposited on the first metal strip for completing tunnel junction. In a step **1765** a trench in the first metal strip may be formed by etching away material from the top of the first metal strip from unprotected region. Trench depth may be controlled to facilitate the bridging of desired molecule between the first and the second metal strips. In a step **1770,** the trench region, the first insulator (Insulator-1), may be created by plasma oxidation of the first metal strip. For this objective metal, the first electrode may be made up of a metal that produces good quality surface oxide to serve as an insulator (insulator -1). Exemplary metals are Titanium, Tantalum, and Nickel. However, if the metal is unable to produce the good oxide, insulator-1 may be produced by adding a monolayer of insulating molecules by the self-assembly process in the trench region. In a step **1775,** a second insulator (insulator-2) may be deposited on the top of the insulator-1 surface. Insulator-2 may be alumina (AlOx), magnesium oxide (MgO), silicon dioxide, silicon nitride, etc. In a step **1780,** a second metal strip may be deposited on the top of at least one insulator. In a step **1785** photoresist layer and the materials sitting on the photoresist may be removed by the liftoff step. Liftoff may result in the tunnel junction testbed with the exposed side edges. In a step **1790,** a junction may be submerged in the molecular solution to connect molecular bridges between the first and the second metal strips.

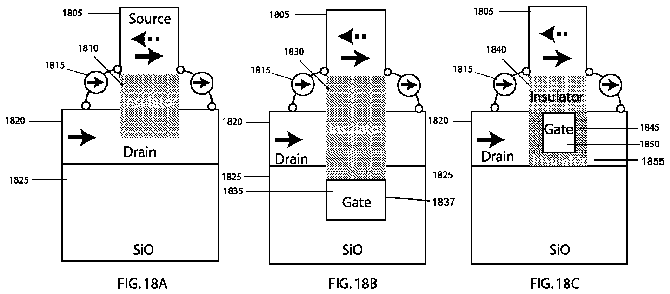

**FIGs. 18A-C** illustrate variations of an exemplary TBELMD, wherein **FIG. 18A** shows a standard TBELMD, **FIG. 18B** shows a TBELMD with a gate electrode in a deep trench, and **FIG. 18C** shows a TBELMD with a gate electrode in a drain electrode, in accordance with an embodiment of the invention. In contrast with the previously disclosed TBELMD as shown in **FIG. 18A****,** alternative embodiments shown in **FIGs. 18B-C** may include a gate electrode within the molecular device. Both alternative embodiments may depend on creating a trench within the bottom electrode. As will be appreciated by one skilled in the art, all three embodiments may still include source electrode **1805,** insulator 1810, molecules **1815,** drain electrode **1820,** and insulating substrate **1825.**

With reference to **FIG. 18B****,** a first approach is shown wherein gate electrode **1835** is deposited within a deep trench **1837** and within insulating substrate **1825.** The deep trench may be produced by creating a deep channel in bottom electrode **1825** with gate electrode **1835** placed at the bottom of the trench. In the resulting configuration, insulator **1830** and source electrode **1805** may be deposited above gate electrode **1835,** and molecules **1815** may be placed on the exposed side edges of the deep, trenched based molecular device. In the deep trench, gate electrode **1835** may be expected to provide an electric field to maneuver the molecular device's states when a current is flowing between source electrode **1805** and drain electrode **1820.**

With reference to **Fig. 18C****,** gate electrode **1850** may be disposed within drain electrode **1820.** A trench **1855** may be created within drain electrode **1820,** and gate electrode **1850** may be placed in the trench so that gate electrode **1820** is insulated from source electrode **1805** and drain electrode **1820** via first insulator **1840** and second insulator **1845,** respectively. The charge transport between source electrode **1805** and drain electrode **1820** via the molecular channel may be influenced by an electric field induced by gate electrode **1850.**

The configurations shown in **Figs. 18B-C** may be equivalent to CMOS-based logic devices used in current silicon-based transistor technology.

**FIGs. 19A-E** illustrate an exemplary TBELMD with a gate electrode within a drain area, wherein **FIG. 19A** illustrates a top view of a TBELMD with a gate electrode within a drain area, **FIG. 19B** illustrates a first cross-sectional view of a TBELMD with a gate electrode within a drain area along **1925** dashed line shown in **FIG. 19A, FIG. 19C** illustrates a 3D view of a TBELMD with a gate electrode within a drain area, **FIG. 19D** illustrates a second cross-sectional view of a TBELMD with a gate electrode within a drain area along **1930** dashed line shown in **FIG. 19A,** and **FIG. 19E** illustrates a third cross-sectional view of a TBELMD with a gate electrode within a drain area along **1935** dashed line shown in **FIG. 19A****,** in accordance with an embodiment of the invention. With reference to **FIG. 19A****,** the components of TBELMD **1900,** which may include, for example, without limitation, gate electrode extension (GEE) **1915,** source **1910,** drain **1920,** etc. may be deposited on insulating substrate **1905.** TBELMD **1900** may include gate **1915** within drain **1920** in order to maximize the effect of gate **1915** on the molecular channel and reduce the leakage current between gate **1915,** source **1910,** and drain **1920.** As shown, gate **1915** and drain **1920** may be deposited parallel to each other, while source **1910** may be deposited on top of and perpendicular to gate **1915** and drain **1920.** The structure of TBELMD **1900** will be discussed in further detail below with reference to **FIGs. 19B-E**, which illustrate various cross-sectional and 3D views of TBELMD **1900.**

With reference to **FIG. 19B****,** a first cross-sectional view **1925** of TBELMD **1900** is shown, looking in from the right side of **FIG. 19A****,** along 1925 dashed line shown in **FIG. 19A****.** Drain **1920** and source **1910** may be composed of ferromagnetic metals, such as, without limitation, cobalt, iron, nickel, nickel-iron, gadolinium, etc. Drain **1920** may include trench **1960** wherein insulation **1955** may be deposited on the inner walls of trench **1960,** and gate electrode **1950** may be deposited within the trench area. Insulation **1960** may be aluminum oxide (AlOx), magnesium oxide (MgO), Titanium oxide (TiO), Tantalum oxide etc. Gate electrode **1950** may preferably be composed of aluminum-like oxidizable material yielding high quality insulator **1945** on the surface. Material of 1945 may be aluminum, tantalum, titanium, nickel, etc. The thickness of gate electrode **1950** may vary depending on various circumstances, but should be so thick as to enable the oxide making up high quality insulator **1945** to protrude out of trench **1960** due to surface oxidation or with additional insulator deposition, and less than the length of molecular channel **1940.** High quality insulator **1945** ensures separation of gate electrode **1950** from source **1910,** while insulation **1955** ensures separation of gate electrode **1950** from drain **1920.** After separation of gate electrode **1950** from source **1910** and drain **1920,** molecular channels **1940** may be connected between source **1910** and drain **1920.** During operation, transport between source **1910** and drain **1920** may occur via molecular channels **1950.** Gate electrode **1950** may create an electric field along the exposed sides of insulator **1945** to switch molecular states and produce bi-stable or multi-level molecular devices.

With reference to **FIG. 19C****,** a 3D view of TBELMD is shown. Molecules making up molecular channel **1940** may be placed between source **1910** and drain **1920.** GEE **1915** may be an extension of gate electrode **1950,** and may allow physical contact with the outer world to apply gate voltage. All the depositions of insulation **1955,** gate electrode **1950,** high quality insulator **1945,** and source **1910** may be fabricated using the same trench in order to ensure a sharp and exposed side edge. The realization of the exposed edges may be accomplished by depositing all the films via the same photoresist cavity according to the lift off based molecular device fabrication method described above, with reference to **FIGs. 7A-E** GEE **1915** may be a continuous layer under source **1910,** high quality insulator **1945,** gate electrode **1450,** and insulation **1955.** As shown by the hump near GEE **1915.** A connection may be established between GEE **1915** and gate electrode **1950,** which may reach closest to the molecule junction area located across high quality insulator **1945** between source **1910** and drain **1920.** Hence, this arrangement ensures that gate electrode **1450** are closest to molecular channel **1940.** Hence, when a voltage is applied to GEE **1915,** an electric field may be produced in high quality insulation **1945.** GEE **1915** may additionally be designed with specific properties to enable connection with gate electrode **1950.** GEE **1915** may be designed to have sharp side edges, which may poke through insulation **1955.** The role of **1955 is to** isolate drain **1920** from gate electrode **1950** underneath molecular junction area in the trench region. However, insulator **1955 must** be broken to ensure good electrical connection between GEE **1915** and gate electrode **1950.** Sharp features, along with GEE **1915,** may ensure that the thickness around the edges of insulation **1955** is sufficiently small to make an electrical short circuit with gate electrode **1950.** The short circuit between GEE **1915** and gate electrode **1950** may also be ensured by the application of a breakdown voltage to insulation **1955.** High quality insulator **1945** may serve dual functions: work as a molecular length scale spacer between source **1910** and drain **1920,** and apply an electric field on molecular channels **1940.** The deposition of insulation **1955** may be accomplished by the oxidation of gate electrode **1950** if gate electrode **1950** is composed of oxidizable materials such as, but not limited to, aluminum, tantalum, titanium, and silicon. Insulation **1955** may also be deposited separately. Subsequently, source **1910** may be deposited to complete the tunnel junction test bed with gate electrode **1950.** Molecular channels **1940** may be covalently bonded between drain **1920** and source **1910** along their respective exposed sides, as discussed in **FIG**. **8****.**

With reference to **FIG. 19D****,** second cross section **1930** is shown. As depicted, drain 1920 may be separated from gate **1950**. The area between drain **1920** and gate **1950** may be divided by insulation **1955**. Insulation **1955** may fully cover the wall of trench **1960** within drain **1920.** Dashed area **1965** within insulation **1955** may represent the area of the wall of trench **1960.**

With reference to **FIG. 19E****,** third cross section **1935** is shown. As depicted, gate electrode **1950** may be directly behind insulation **1955** and connected to GEE **1915**.

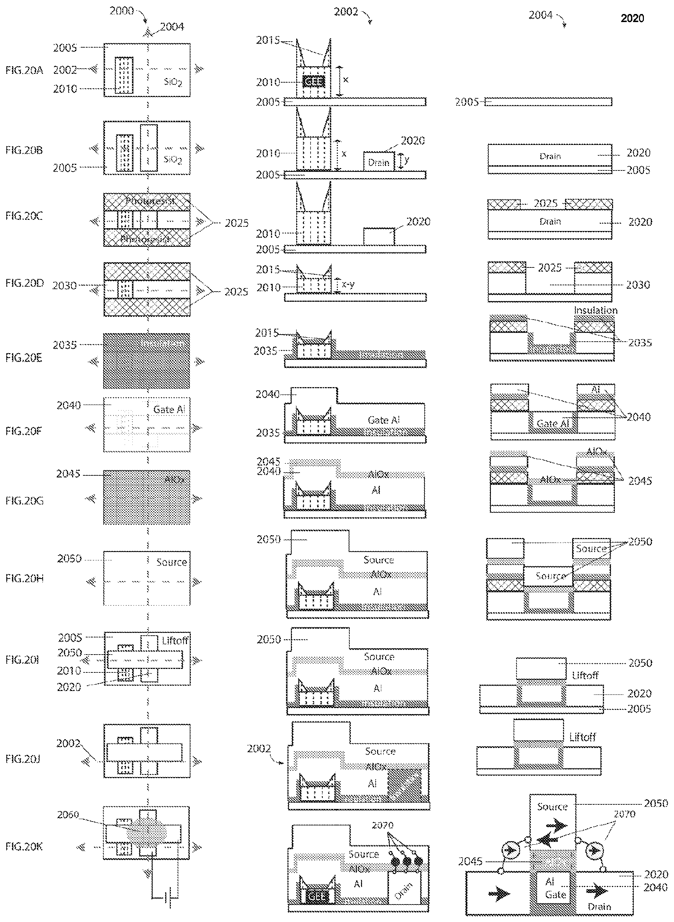

**FIGs. 20A-K** illustrate, by way of example, various top and cross-sectional views of the components of an exemplary TBELMD with a gate electrode within a drain area, at each stage of an exemplary process flow for creating the TBELMD with a gate electrode within a drain area, in accordance with an embodiment of the invention. In order to demonstrate the fabrication process for a TBELMD with a gate electrode within a drain area, **FIGs. 20A-K** depict a top view **2000** of the manufacturing process along vertical cross-sectional view **2002** and horizontal cross-sectional view **2004.** In a step (**FIG. 20A****)** gate electrode extension (GEE) **2010** may be deposited on insulating substrate **2005.** GEE **2010** may include sharp spikes **2115** along its edges, which may be obtained via thin film deposition within a photolithography cavity with a shallow sidewall profile. In a step (**FIG. 20B****)** drain electrode **2020** may be deposited on insulating substrate **2005.** The thickness of drain electrode **2020** may be different than GEE **2010** as drain electrode **2020** to accommodate for subsequent etching steps to be described in further detail below. In a step (**FIG. 20C**) photolithography may be performed to protect the GEE **2010** and drain electrode **2020** in sections to be protected from subsequent etching. The areas under photoresist layers **2025** may be protected from the etching to be performed. In a step (**FIG. 20D****)** deep trench **2030** may be created via etching of the area not under PR layer **2025.** The complete removal of drain electrode **2020** within deep trench **2030** ensures a minimum indirect contact interface area with a metal gate electrode, to be deposited in **FIG. 20F** below. However, the etching may reduce the thickness of GEE **2010,** and a sufficient amount of thickness of GEE **2010** may be left to make a direct electrical connection between GEE **2010** and the later deposited gate electrode. Further, sharp spikes **2015** may remain. The thickness of GEE **2010** may smaller than the difference in thickness between original GEE **2010** and drain **2020.** In a step (**FIG. 20E****)** insulation **2035** may be deposited, ensuring coverage of the sidewall of drain electrode **2020,** as can be seen in horizontal cross-sectional view **2004.** Insulation **2035** may on top of PR layer **2025** may be removed in a later step in the fabrication process, resulting in insulation **2035** to solely be deposited within deep trench **2030.** Insulation **2035** may be of an optimum thickness to ensure the prevention of a short circuit between the wall of drain electrode **2020** and the to be deposited drain electrode, while simultaneously thin enough to ensure an electrical short between sharp edges **2015** of GEE **2010** and the to be deposited drain electrode. In a step (**FIG. 20F****)** gate electrode **2040** may be deposited on top of insulation **2035.** Gate electrode **2040** may be composed of an oxidizable metal such as, without limitation, aluminum, tantalum, and titanium, to aid in the creation of insulation to be described in a subsequent step. In a step (**FIG. 20G****)** gate electrode **2040** may be oxidized to form tunnel barrier **2045** on the top surface of gate electrode **2040.** In the preferred embodiment, tunnel barrier **2045** may be an aluminum oxide (AlOx), but, as will be appreciated by one skilled in the art, may be another oxide depending on the material of gate electrode **2040.** Tunnel barrier **2045** may act as an insulating layer between drain electrode **2020** and a source electrode to be subsequently deposited. Tunnel barrier **2045** may be formed along the full length of gate electrode **2040** to ensure a solid insulating gap between gate electrode **2040** and the source electrode to be deposited. After oxidation, the thickness of tunnel barrier **2045** extending out of drain electrode **2020** may be decided based on the length of a target molecule. In a step (**FIG. 20H**) source electrode **2050** may be deposited and cover the full length of tunnel barrier **2045.** Source electrode **2050** may be composed of magnetic and nonmagnetic materials, such as nickel, cobalt, nickel-iron, cobalt-iron, gold, without limitation, In a step (**FIG. 20I**) Liftoff of PR layer **2025** may result in the washing off of every layer on top of PR layer **2025.** After liftoff, only layers directly in contact with insulating substrate **2005** will remain. The remaining materials may remain unchanged after liftoff, resulting in the exposing of the edges of source electrode **2050** and drain electrode **2020.** To further illustrate the subsequent molecular bridging step, the panels in **FIG. 20J** may represent a shift in horizontal cross-sectional view **2002** to the bottom edge of deep trench **2030.** In a step (**FIG. 20K**) a junction area between source electrode **2050** and drain electrode **2020** may be exposed to molecular solution **2055** in order to create a molecular channel between source electrode **2050** and drain electrode **2020** via molecules **2060.** The molecular channels may only create a bridge where drain electrode **2040** is present underneath source electrode **2050,** and will further be separated from gate electrode **2040.** Gate electrode **2040** may induce an electric field in tunnel barrier **2045** and along the edges of source electrode **2050** and drain electrode **2020.** This electric field may influence the transport channel via a molecule. Electric field application may also impact the molecular quantum states, including spin states, allowing the TBELMD to function as a bistable device switching between two conductance states similar to traditional CMOS transistors. The electric field from gate electrode **2040** may also force a molecule to acquire multiple switchable quantum states and produce unprecedented molecular computational devices like quantum computing devices.

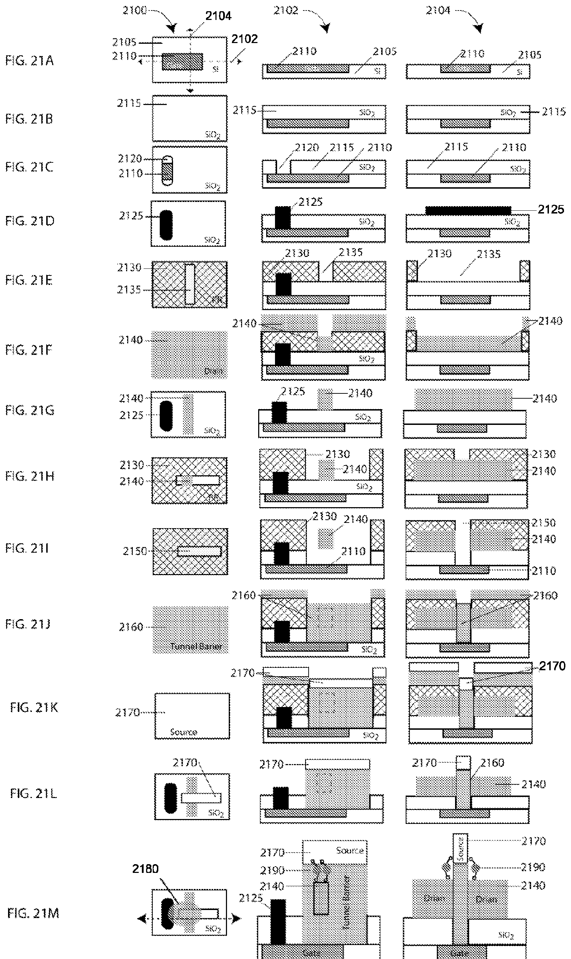

**FIGs. 21A-M** illustrate, by way of example, various top and cross-sectional views of the components of an exemplary TBELMD with a gate electrode in a deep trench, at each stage of an exemplary process flow for creating the TBELMD with a gate electrode in a deep trench, in accordance with an embodiment of the invention. In order to demonstrate the fabrication process for a TBELMD with a gate electrode in a deep trench, **FIGs. 21A-M** depict a top view **2100** of the manufacturing process along vertical cross-sectional view **2102** and horizontal cross-sectional view **2104.** In a step (**FIG. 21A**) conducting gate electrode **2110** may be deposited on substrate **2105** via an ion implantation method on the silicon wafer. Gate electrode **2110** may also be formed by the deposition of a conducting metal or alloy, such as, but not limited to, tantalum, tungsten, titanium, titanium nitride, tungsten nitride, etc., in the photolithographically defined region on substrate **2105.** In a step (**FIG. 21B**) after gate electrode **2110** is deposited on substrate **2105,** gate electrode **2110** and substrate **2105** may be covered with insulating layer **2115.** Insulating layer **2115** may be composed of, for example, without limitation, silicon dioxide. The thickness of insulating layer **2115** may be optimized to make a balance between two competing requirements: thick enough to ensure the lowest leakage current between the gate and source/drain electrodes (as will be deposited in the subsequent stages of the current process), and thin enough to enable the gate electrode to apply a desired amount of electric field on nearby molecular channels. In a step (**FIG. 21C**) an etching process may be used to create hole **2120** in insulating layer **2115.** Hole **2120** may allow an electrical connection with gate electrode **2110** with the gate electrode extension GEE. In a step (**FIG. 21D**) conducting layer may be deposited into hole **2120** to establish a GEE **2125.** Voltage may be applied to gate electrode **2110** via GEE **2125.** In a step (**FIG. 21E**) photolithography may be performed on the dimensions and location of drain electrode **2140.** A resulting photoresist (PR) layer **2130** may form (as seen in the top view), and a window **2135** in PR layer **2130** is created to allow the deposition of drain electrode **2140** above insulation layer **2115** (as seen in vertical cross-sectional view **2102**). In a step (**FIG. 21F**) drain electrode **2140** may be deposited, covering the surface, PR region, and empty region. Drain electrode **2140** may be composed of any metal, preferably a magnetic metal, such as nickel, cobalt, nickel-iron, cobalt-iron, iron, without limitation, to allow for the formation of spin-based molecular devices. In a step (**FIG. 21G**) liftoff of photoresist may be used to remove PR layer **2130** and materials sitting on top of PR layer **2130,** exposing drain electrode **2140** and GEE **2125.** In a step (**FIG. 21H**) photolithography may be performed to produce a region for the completion of etching of drain **2140** and insulation layer **2115,** deposition of a tunneling barrier (as will be discussed with reference to **FIG. 21J**), and deposition of a source electrode (as will be discussed with reference to **FIG. 21K**). Note that drain electrode **2140** may still be exposed through a window in photoresist layer **2130.** In a step (**FIG. 21I**) exposed drain electrode material may be removed within window **2150,** with drain **2140** still remaining under PR layer **2130,** resulting in a deep trench formed within drain **2140.** Trench region is shown in region **2150** in section **2104** of Fig. 21I. The depth of the trench may be deep enough to expose gate electrode **2110,** and may be smaller if insulation layer **2115** is to be utilized as a section of insulator material needed between molecular channels **2190** and gate electrode **2110.** In a step (**FIG. 21J**) tunnel barrier **2160** may be deposited within the trench region and on top of PR layer **2130,** such that tunnel barrier **2160** may fill the trench within drain **2140.** The thickness of tunnel barrier **2160** is such that tunnel barrier **2160** may slightly rise above drain **2140,** as shown in horizontal cross-sectional view **2104.** In a step (**FIG. 21K**) source electrode **2170** may be deposited on top of tunneling barrier **2160.** Source electrode **2170** may be composed of magnetic material or multilayers of magnetic material, such as nickel, cobalt, nickel-iron, cobalt-iron, iron, without limitation, etc. The utilization of magnetic electrodes may enable TBELMD to perform as a spin-based device or spin valve. In a step (**FIG. 21L**) liftoff of PR layer **2130** may be performed to expose drain **2140,** GEE **2125,** and remove extra source electrode **2170** material. In a step (**FIG. 21M**) source electrode **2170** and drain **2140** may be exposed to molecular solution **2180** containing the desired target molecular device elements such as, without limitation, single molecular magnets, porphyrin, organometallic clusters, DNA, polymer chains etc. As shown, horizontal cross-sectional view **2102** location is shifted downward to show that molecules **2190** may bridge the gap between source electrode **2170** and drain **2140.** The number of molecules that will be connected between source electrode **2170** and drain **2140** may be governed by the width of drain **2140.** Further, molecules **2190** may be deposited on either side of source **2170,** as shown in vertical cross-sectional view **2104.** In the completed device, gate electrode **2110** may create an electric field sufficient enough to influence the quantum states of molecules **2190.** Changing the molecular states may impact the molecular conductance between source electrode **2170** and drain **2140,** producing multiple device states. The number of molecular device states may differ dramatically based on molecular type and the interaction between molecules **2190,** source electrode **2170,** and drain **2140.**

Those skilled in the art will readily recognize, in light of and in accordance with the teachings of the present invention, that any of the foregoing steps may be suitably replaced, reordered, removed and additional steps may be inserted depending upon the needs of the particular application. Moreover, the prescribed method steps of the foregoing embodiments may be implemented using any physical and/or hardware system that those skilled in the art will readily know is suitable in light of the foregoing teachings. For any method steps described in the present application that can be carried out on a computing machine, a typical computer system can, when appropriately configured or designed, serve as a computer system in which those aspects of the invention may be embodied.

All the features disclosed in this specification, including any accompanying abstract and drawings, may be replaced by alternative features serving the same, equivalent, or similar purpose, unless expressly stated otherwise. Thus, unless expressly stated otherwise, each feature disclosed is one example only of a generic series of equivalent or similar features.

Having fully described at least one embodiment of the present invention, other equivalent or alternative methods of implementing fabrication of electronics according to the present invention will be apparent to those skilled in the art. Various aspects of the invention have been described above by way of illustration, and the specific embodiments disclosed are not intended to limit the invention to the particular forms disclosed. The particular implementation of the fabrication of electronics may vary depending upon the particular context or application. By way of example, and not limitation, the fabrication of electronics described in the foregoing were principally directed to computer logic and memory device implementations; however, similar techniques may instead be applied to chemical and energy sensing, which implementations of the present invention are contemplated as within the scope of the present invention. The invention is thus to cover all modifications, equivalents, and alternatives falling within the scope of the following claims. It is to be further understood that not all of the disclosed embodiments in the foregoing specification will necessarily satisfy or achieve each of the objects, advantages, or improvements described in the foregoing specification.

Claim elements and steps herein may have been numbered and/or lettered solely as an aid in readability and understanding. Any such numbering and lettering in itself is not intended to and should not be taken to indicate the ordering of elements and/or steps in the claims.

The corresponding structures, materials, acts, and equivalents of all means or step plus function elements in the claims below are intended to include any structure, material, or act for performing the function in combination with other claimed elements as specifically claimed.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope of the invention. The embodiment was chosen and described in order to best explain the principles of the invention and the practical application, and to enable others of ordinary skill in the art to understand the invention for various embodiments with various modifications as are suited to the particular use contemplated.

The following claims are hereby incorporated into the detailed description, with each claim standing on its own as a separate embodiment.

## Claims

1. A method comprising the steps of:
depositing a first electrode metal (1820) on an insulating substrate or layer (1825);
creating a trench portion (1837, 1855), in which said trench portion (1837, 1855) comprises a section of said first electrode metal (1820) with a depth;
**characterized in that** the method comprises the further steps of
depositing a gate electrode material (1835, 1850) in said trench portion (1837, 1855);
depositing an insulating component (1840, 1830) above said gate electrode material (1835, 1850); and
depositing a second electrode metal (1805) on said insulating component (1830, 1840), wherein said insulating component (1830, 1840) is configured to separate said gate electrode material (1835, 1850) from said second electrode metal (1805).

2. The method of claim 1, wherein the step of forming said trench portion (1837) comprises forming said trench portion (1837) through said first electrode metal (1820) and a portion of said insulating substrate or layer (1825), wherein said trench portion (1837) comprises a section of both first electrode metal (1820) and insulating substrate or layer (1825).

3. The method of claim 2, wherein the gate electrode material (1835) is deposited in said trench portion (1837) of said portion of said insulating substrate or layer (1825).

4. The method of claim 3, wherein the insulator material (1830) is deposited in said trench portion (1837).

5. The method of claim 4, wherein a thickness of said gate electrode material (1835) and the insulating component (1830) is approximately more than the depth of said trench portion (1837).

6. The method of claim 1, wherein the gate electrode material (1850) is deposited in said trench portion (1855) of said first electrode metal (1820).

7. The method of claim 6, further comprising a step of insulating said gate electrode material (1850) from said first electrode metal (1820) by an insulator material (1845).

8. The method of claim 7, in which said insulating step comprises a step of oxidizing a surface portion of said first electrode metal (1820) to form said insulator material (1845).

9. The method of claim 8, wherein a thickness of said gate electrode material (1850) and insulator material (1845) is approximately at the same depth of said trench portion (1855).

10. The method of any of the previous claims, further comprising a step of engaging said first electrode metal (1820) and second electrode metal (1805) with a molecular bridge (1815).

11. The method of claim 9, further comprising a step of producing a tunnel junction having at least one exposed side edges, from the first electrode metal (1820), the insulator material (1845), the insulating component (1840, 1830), and the second electrode metal (1805).

12. The method of claim 11, in which said molecular bridge (1815) comprises at least a molecule core (815), at least two tethers (810), and at least two thiol anchoring compounds (820).

13. The method of claim 12, in which said step of engaging said first electrode metal (1820) and said second electrode metal (1805) with said molecular bridge (1815) comprises the steps of:
engaging a first end portion of each of said at least two tethers (810) to said molecule core (815); and
engaging said at least two thiol anchoring compounds (820) to a second end portion of each of said at least two tethers (810).

14. The method of claim 12, in which said step of engaging said first electrode metal (1820) and second electrode metal (1805) with said molecular bridge (1815) comprises a step of bonding a first end portion of said at least two thiol anchoring compound (820) to said first electrode metal (1820) and bonding a second end portion of said at least two thiol anchoring compound (820) to said second electrode metal (1805).

15. A system comprising:
an insulating substrate or layer (1825);
a first electrode metal (1820) deposited on said insulating substrate or layer (1825);
a trench portion (1837, 1855), wherein said trench portion (1837, 1855) being a channel created through or on said first electrode metal (1820) with a depth;
**characterized in**
a gate electrode material (1835, 1850) deposited in said trench portion (1837, 1855);
an insulating component (1840, 1830) above said gate electrode material (1835, 1850);
a second electrode metal (1805) on said insulating component (1830, 1840), wherein said insulating component (1830, 1840) is configured to separate said gate electrode material (1835, 1850) and said second electrode metal (1805).

16. The system of claim 15, further comprising a molecular bridge (1815), wherein said molecular bridge (1815) is configured to engage said first electrode metal (1820) to said second electrode metal (1805), in which said molecular bridge (1815) comprises:
at least a molecule core (815);
at least two tethers (810); and
at least two thiol anchoring compounds (820).

17. A system of any of claims 15 or 16, wherein said trench portion (1837) being a channel created through said first electrode metal (1820) and a portion of said insulating substrate or layer (1825) with a depth;
the system further comprising
an insulator material (1845) that is configured to insulate said gate electrode material (1850) from said first electrode metal (1820).

18. The system of claim 17, wherein said insulator material (1845) comprises an oxidized surface portion of said first electrode metal (1820).

## Patentansprüche

1. Verfahren, umfassend die Schritte:
Abscheiden eines ersten Elektrodenmetalls (1820) auf ein Isoliersubstrat bzw. Isolierschicht (1825);
Erzeugen eines Grabenabschnitts (1837, 1855), wobei der Grabenabschnitt (1837, 1855) einen Bereich des ersten Elektrodenmetalls (1820) mit einer Tiefe umfasst;
**dadurch gekennzeichnet, dass** das die weiteren folgenden Schritte umfasst:
Abscheiden eines Gate-Elektrodenmaterials (1835, 1850) in den Grabenabschnitt (1837, 1855);
Abscheiden einer Isolierkomponente (1840, 1830) oberhalb des Gate-Elektrodenmaterials (1835, 1850); und
Abscheiden eines zweiten Elektrodenmetalls (1805) auf die Isolierkomponente (1830, 1840), wobei die Isolierkomponente (1830, 1840) konfiguriert ist, um das Gate-Elektrodenmaterial (1835, 1850) von dem zweiten Elektrodenmetall (1805) zu trennen.

2. Verfahren nach Anspruch 1, wobei der Schritt eines Bildens des Grabenabschnitts (1837) ein Bilden des Grabenabschnitts (1837) durch das erste Elektrodenmetall (1820) und einen Abschnitt des Isoliersubstrats bzw. Isolierschicht (1825) umfasst, wobei der Grabenabschnitt (1837) einen Bereich sowohl des ersten Elektrodenmetalls (1820) als auch d des Isoliersubstrats bzw. Isolierschicht (1825) umfasst.

3. Verfahren nach Anspruch 2, wobei das Gate-Elektrodenmaterial (1835) in den Grabenabschnitt (1837) des Abschnitts des Isoliersubstrats bzw. Isolierschicht (1825) abgeschieden wird.

4. Verfahren nach Anspruch 3, wobei das Isoliermaterial (1830) in den Grabenabschnitt (1837) abgeschieden wird.

5. Verfahren nach Anspruch 4, wobei eine Stärke des Gate-Elektrodenmaterials (1835) und der Isolierkomponente (1830) ungefähr größer ist als die Tiefe des Grabenabschnitts (1837).

6. Verfahren nach Anspruch 1, wobei das Gate-Elektrodenmaterial (1850) in den Grabenabschnitt (1855) des ersten Elektrodenmetalls (1820) abgeschieden wird.

7. Verfahren nach Anspruch 6, ferner umfassend einen Schritt eines Isolierens des Gate-Elektrodenmaterials (1850) von dem ersten Elektrodenmetall (1820) durch ein Isoliermaterial (1845).

8. Verfahren nach Anspruch 7, wobei der Isolierschritt einen Schritt eines Oxidierens eines Oberflächenabschnitts des ersten Elektrodenmetalls (1820) zum Bilden des Isoliermaterials (1845) umfasst.

9. Verfahren nach Anspruch 8, wobei eine Stärke des Gate-Elektrodenmaterials (1850) und des Isoliermaterials (1845) ungefähr auf derselben Tiefe wie der Grabenabschnitt (1855) ist.

10. Verfahren nach einem der vorherigen Ansprüche, ferner umfassend einen Schritt des Verbindens des ersten Elektrodenmetalls (1820) und des zweiten Elektrodenmetalls (1805) mit einer molekularen Brücke (1815).

11. Verfahren nach Anspruch 9, ferner umfassend einen Schritt eines Erzeugens einer Tunnelverbindung, die mindestens einen freiliegenden Seitenrand aufweist, aus dem ersten Elektrodenmetall (1820), dem Isoliermaterial (1845), der Isolierkomponente (1840, 1830) und dem zweiten Elektrodenmetall (1805).

12. Verfahren nach Anspruch 11, wobei die molekulare Brücke (1815) mindestens einen Molekülkern (815), mindestens zwei Tether (810) und mindestens zwei Thiol-Ankerverbindungen (820) umfasst.

13. Verfahren nach Anspruch 12, wobei der Schritt eines Verbindens des ersten Elektrodenmetalls (1820) und des zweiten Elektrodenmetalls (1805) mit der molekularen Brücke (1815) die folgenden Schritte umfasst:
Eingreifen eines ersten Endabschnitts von jedem der mindestens zwei Tether (810) mit dem Molekülkern (815); und
Eingreifen der mindestens zwei Thiol-Ankerverbindungen (820) mit einem zweiten Endabschnitt von jedem der mindestens zwei Tether (810).

14. Verfahren nach Anspruch 12, wobei der Schritt eines Eingreifens des ersten Elektrodenmetalls (1820) und des zweiten Elektrodenmetalls (1805) mit der molekularen Brücke (1815) einen Schritt eines Bindens eines ersten Endabschnitts der mindestens zwei Thiol-Ankerverbindung (820) an das erste Elektrodenmetall (1820) und eines Bindens eines zweiten Endabschnitts der mindestens zwei Thiol-Ankerverbindung (820) an das zweite Elektrodenmetall (1805) umfasst.

15. System, umfassend:
ein Isoliersubstrat bzw. Isolierschicht (1825);
ein erstes Elektrodenmetall (1820), abgeschieden auf das Isoliersubstrat bzw. Isolierschicht (1825);
einen Grabenabschnitt (1837, 1855), wobei der Grabenabschnitt (1837, 1855) ein Kanal ist, der durch den oder auf dem ersten Elektrodenmetall (1820) mit einer Tiefe erzeugt ist;
**gekennzeichnet durch**
ein Gate-Elektrodenmaterial (1835, 1850), abgeschieden in den Grabenabschnitt (1837, 1855);
eine Isolierkomponente (1840, 1830) oberhalb des Gate-Elektrodenmaterials (1835, 1850);
ein zweites Elektrodenmetall (1805) auf der Isolierkomponente (1830, 1840), wobei die Isolierkomponente (1830, 1840) konfiguriert ist, um das Gate-Elektrodenmaterial (1835, 1850) und das zweite Elektrodenmetall (1805) zu trennen.

16. System nach Anspruch 15, ferner umfassend eine molekulare Brücke (1815),
wobei die molekulare Brücke (1815) konfiguriert ist, um das erste Elektrodenmetall (1820) mit dem zweiten Elektrodenmetall (1805) zu verbinden, wobei die molekulare Brücke (1815) Folgendes umfasst:
mindestens einen Molekülkern (815);
mindestens zwei Tether (810); und
mindestens zwei Thiol-Ankerverbindungen (820).

17. System nach einem der Ansprüche 15 oder 16, wobei der Grabenabschnitt (1837) ein Kanal ist, der durch das erste Elektrodenmetall (1820) und einen Abschnitt des Isoliersubstrats bzw. Isolierschicht (1825) mit einer Tiefe erzeugt ist;
das System ferner umfassend
ein Isoliermaterial (1845), das konfiguriert ist, um das Gate-Elektrodenmaterial (1850) von dem ersten Elektrodenmetall (1820) zu isolieren.

18. System nach Anspruch 17, wobei das Isoliermaterial (1845) einen oxidierten Oberflächenabschnitt des ersten Elektrodenmetalls (1820) umfasst.

## Revendications

1. Procédé comprenant les étapes de :
dépôt d'un premier métal d'électrode (1820) sur un substrat ou une couche isolant(e) (1825) ;
création d'une portion de tranchée (1837, 1855), dans laquelle ladite portion de tranchée (1837, 1855) comprend une section dudit premier métal d'électrode (1820) avec une profondeur ;
**caractérisé en ce que** le procédé comprend en outre les étapes de
dépôt d'un matériau d'électrode de grille (1835, 1850) dans ladite portion de tranchée (1837, 1855) ;
dépôt d'un composant isolant (1840, 1830) au-dessus dudit matériau d'électrode de grille (1835, 1850) ; et
dépôt d'un deuxième métal d'électrode (1805) sur ledit composant isolant (1830, 1840), dans lequel ledit composant isolant (1830, 1840) est configuré pour séparer ledit matériau d'électrode de grille (1835, 1850) dudit deuxième métal d'électrode (1805).

2. Procédé selon la revendication 1, dans lequel l'étape de formation de ladite portion de tranchée (1837) comprend la formation de ladite portion de tranchée (1837) à travers ledit premier métal d'électrode (1820) et une portion dudit substrat ou de ladite couche isolant(e) (1825), dans lequel ladite portion de tranchée (1837) comprend une section à la fois du premier métal d'électrode (1820) et du substrat ou de la couche isolant(e) (1825).

3. Procédé selon la revendication 2, dans lequel le matériau d'électrode de grille (1835) est déposé dans ladite portion de tranchée (1837) de ladite portion dudit substrat ou de ladite couche isolant(e) (1825).

4. Procédé selon la revendication 3, dans lequel le matériau isolant (1830) est déposé dans ladite portion de tranchée (1837).

5. Procédé selon la revendication 4, dans lequel une épaisseur dudit matériau d'électrode de grille (1835) et du composant isolant (1830) est approximativement supérieure à la profondeur de ladite portion de tranchée (1837).

6. Procédé selon la revendication 1, dans lequel le matériau d'électrode de grille (1850) est déposé dans ladite portion de tranchée (1855) dudit premier métal d'électrode (1820).

7. Procédé selon la revendication 6, comprenant en outre une étape d'isolation dudit matériau d'électrode de grille (1850) dudit premier métal d'électrode (1820) par un matériau isolant (1845).

8. Procédé selon la revendication 7, dans lequel ladite étape d'isolation comprend une étape d'oxydation d'une portion de surface dudit premier métal d'électrode (1820) pour former ledit matériau isolant (1845).

9. Procédé selon la revendication 8, dans lequel une épaisseur dudit matériau d'électrode de grille (1850) et du matériau isolant (1845) est approximativement égale à la profondeur de ladite portion de tranchée (1855).

10. Procédé selon l'une quelconque des revendications précédentes, comprenant en outre une étape de mise en contact dudit premier métal d'électrode (1820) et du deuxième métal d'électrode (1805) avec un pont moléculaire (1815).

11. Procédé selon la revendication 9, comprenant en outre une étape de production d'une jonction tunnel ayant au moins un bord latéral exposé, à partir du premier métal d'électrode (1820), du matériau isolant (1845), du composant isolant (1840, 1830) et du deuxième métal d'électrode (1805).

12. Procédé selon la revendication 11, dans lequel ledit pont moléculaire (1815) comprend au moins un noyau moléculaire (815), au moins deux chaînes (810) et au moins deux composés d'ancrage thiol (820).

13. Procédé selon la revendication 12, dans lequel ladite étape de mise en contact dudit premier métal d'électrode (1820) et dudit deuxième métal d'électrode (1805) avec ledit pont moléculaire (1815) comprend les étapes de :
mise en contact d'une première portion d'extrémité de chacune desdites au moins deux chaînes (810) avec ledit noyau moléculaire (815) ; et
mise en contact desdits au moins deux composés d'ancrage thiol (820) avec une deuxième portion d'extrémité de chacune desdites au moins deux chaînes (810).

14. Procédé selon la revendication 12, dans lequel ladite étape de mise en contact dudit premier métal d'électrode (1820) et du deuxième métal d'électrode (1805) avec ledit pont moléculaire (1815) comprend une étape de liaison d'une première portion d'extrémité desdits au moins deux composés d'ancrage thiol (820) audit premier métal d'électrode (1820) et de liaison d'une deuxième portion d'extrémité desdits au moins deux composés d'ancrage thiol (820) audit deuxième métal d'électrode (1805).

15. Système comprenant :
un substrat ou une couche isolant(e) (1825) ;
un premier métal d'électrode (1820) déposé sur ledit substrat ou ladite couche isolant(e) (1825) ;
une portion de tranchée (1837, 1855), dans lequel ladite portion de tranchée (1837, 1855) est un canal créé à travers ou sur ledit premier métal d'électrode (1820) avec une profondeur ;
**caractérisé par**
un matériau d'électrode de grille (1835, 1850) déposé dans ladite portion de tranchée (1837, 1855) ;
un composant isolant (1840, 1830) au-dessus dudit matériau d'électrode de grille (1835, 1850) ;
un deuxième métal d'électrode (1805) sur ledit composant isolant (1830, 1840), dans lequel ledit composant isolant (1830, 1840) est configuré pour séparer ledit matériau d'électrode de grille (1835, 1850) et ledit deuxième métal d'électrode (1805).

16. Système selon la revendication 15, comprenant en outre un pont moléculaire (1815), dans lequel ledit pont moléculaire (1815) est configuré pour mettre en contact ledit premier métal d'électrode (1820) avec ledit deuxième métal d'électrode (1805), dans lequel ledit pont moléculaire (1815) comprend :
au moins un noyau moléculaire (815) ;
au moins deux chaînes (810) ; et
au moins deux composés d'ancrage thiol (820).

17. Système selon l'une quelconque des revendications 15 ou 16, dans lequel ladite portion de tranchée (1837) est un canal créé à travers ledit premier métal d'électrode (1820) et une portion dudit substrat ou de ladite couche isolant(e) (1825) avec une profondeur ;
le système comprenant en outre
un matériau isolant (1845) qui est configuré pour isoler ledit matériau d'électrode de grille (1850) dudit premier métal d'électrode (1820).

18. Système selon la revendication 17, dans lequel ledit matériau isolant (1845) comprend une portion de surface oxydée dudit premier métal d'électrode (1820).
